# EUROPEAN PATENT SPECIFICATION

(11) **EP 3 193 376 B1**
(45) Date of publication and mention of the grant of the patent: **20.03.2019**
(21) Application number: 17151203.1
(22) Date of filing: 12.01.2017
(51) Int. Cl.: H01L 31/0224, H01L 31/0368, H01L 31/068, H01L 31/18

(54) **SOLAR CELL AND METHOD OF MANUFACTURING THE SAME**
SOLARZELLE UND VERFAHREN ZUR HERSTELLUNG DAVON
CELLULE SOLAIRE ET SON PROCÉDÉ DE FABRICATION

(30) Priority: 12.01.2016 KR 20160003753
(43) Date of publication of application: 19.07.2017
(73) Proprietor: LG ELECTRONICS INC., Yeongdeungpo-gu Seoul, 07336 (KR)
(72) Inventor: LEE, Yujin, 08592 Seoul (KR); CHUNG, Jinwon, 08592 Seoul (KR); JI, Kwangsun, 08592 Seoul (KR)
(74) Representative: Katérle, Axel

(56) References cited:
- EP-A1- 2 787 541
- EP-A1- 2 955 760
- EP-A1- 3 185 307
- US-A- 4 249 957
- US-A- 5 269 852
- US-A- 5 403 771

## Description

### BACKGROUND OF THE INVENTION

### 1. Field of the invention

Embodiments of the present invention relate to a solar cell having an improved structure and a method of manufacturing the same.

### 2. Description of the Related Art

Recently, due to depletion of existing energy resources, such as oil and coal, interest in alternative sources of energy to replace the existing energy resources is increasing. Most of all, solar cells are popular next generation cells to convert sunlight into electrical energy.

Solar cells may be manufactured by forming various layers and electrodes based on some design. The efficiency of solar cells may be determined by the design of the various layers and electrodes. In order for solar cells to be commercialized, the problems of low efficiency and low productivity need to be overcome, and thus there is a demand for a solar cell and a method of manufacturing the same, which may maximize the efficiency and productivity of the solar cell. EP 2 955 760 A1 discloses a method for manufacturing a solar cell comprising forming a tunneling layer on a semiconductor substrate, forming a semiconductor layer on the tunneling layer, wherein the forming of the semiconductor layer includes depositing a semiconductor material, and forming an electrode connected to the semiconductor layer, wherein the tunneling layer is formed under a temperature higher than room temperature and a pressure lower than atmospheric pressure.

### SUMMARY OF THE INVENTION

According to one aspect of the present invention, there is provided a solar cell including a semiconductor substrate, a protective-film layer formed over one surface of the semiconductor substrate, a first conductive area disposed over the protective-film layer, the first conductive area being of a first conductive type and including a crystalline semiconductor, and a first electrode electrically connected to the first conductive area, wherein the first conductive area includes a first portion disposed over the protective-film layer and having a first crystal grain size, and a second portion disposed over the first portion and having a second crystal grain size, which is greater than the first crystal grain size, characterized in that a doping concentration of the first portion is lower than that of the second portion.

According to another aspect of the present invention, there is provided a method of manufacturing a solar cell including forming a protective-film layer over a semiconductor substrate, forming a conductive area having crystallinity over the protective-film layer, and forming an electrode electrically connected to the conductive area, wherein, in the forming the conductive area, the conductive area is formed to include a first portion, which is disposed over the protective-film layer and has a first crystal grain size, and a second portion, which is disposed over the first portion and has a second crystal grain size, which is greater than the first crystal grain size, and doping the conductive area, characterized in that a doping concentration of the first portion is lower than that of the second portion.

### BRIEF DESCRIPTION OF THE DRAWINGS

The above and other objects, features and other advantages of the present invention will be more clearly understood from the following detailed description taken in conjunction with the accompanying drawings, in which:
FIG. 1 is a cross-sectional view illustrating a solar cell according to an embodiment of the present invention;
FIG. 2 is a partial rear plan view of the solar cell illustrated in FIG. 1;
FIGS. 3A to 3G are cross-sectional views illustrating a method of manufacturing a solar cell according to an embodiment of the present invention;
FIGS. 4A to 4C are cross-sectional views illustrating a portion of a manufacturing method according to another embodiment of the present invention;
FIGS. 5A to 5D are cross-sectional views illustrating a portion of a manufacturing method according to another embodiment of the present invention;
FIG. 6 is a cross-sectional view illustrating a solar cell according to another embodiment of the present invention;
FIG. 7 is a cross-sectional view illustrating a solar cell according to another embodiment of the present invention;
FIG. 8 is a cross-sectional view illustrating a solar cell according to another embodiment of the present invention;
FIG. 9 is a cross-sectional photograph of a first solar cell of Manufacturing Example 1;
FIG. 10 is a cross-sectional photograph of a first comparative solar cell of Comparative Example 1;
FIG. 11 is a graph illustrating the sheet resistance of a first conductive area of first to fourth solar cells and the implied open-circuit voltage Vimp of the first to fourth solar cells according to Manufacturing Example 1;
FIG. 12 is a graph illustrating the sheet resistance of a first conductive area of first to third comparative solar cells and the implied open-circuit voltage of the first to third comparative solar cells according to Comparative Example 1; and
FIG. 13 is a graph illustrating the relative value of carrier mobility in a first conductive area of the first solar cell according to Manufacturing Example 1, the first comparative solar cell according to Comparative Example 1, and solar cells according to Comparative Example 2 and Manufacturing Examples 2 to 4.

### DETAILED DESCRIPTION OF THE EMBODIMENTS

Reference will now be made in detail to the embodiments of the present invention, examples of which are illustrated in the accompanying drawings. However, it will be understood that the present invention should not be limited to the embodiments and may be modified in various ways.

In the drawings, to clearly and briefly explain the present invention, illustration of elements having no connection with the description is omitted, and the same or extremely similar elements are designated by the same reference numerals throughout the specification. In addition, in the drawings, for more clear explanation, the dimensions of elements, such as thickness, width, and the like, are exaggerated or reduced, and thus the thickness, width, and the like of the present invention are not limited to the illustration of the drawings.

In the entire specification, when an element is referred to as "including" another element, the element should not be understood as excluding other elements so long as there is no special conflicting description, and the element may include at least one other element. In addition, it will be understood that, when an element such as a layer, film, region or substrate is referred to as being "on" another element, it can be directly on the other element or intervening elements may also be present. On the other hand, when an element such as a layer, film, region or substrate is referred to as being "directly on" another element, this means that there are no intervening elements therebetween.

Hereinafter, a solar cell and a method of manufacturing the same according to the embodiments of the present invention will be described in detail with reference to the accompanying drawings.

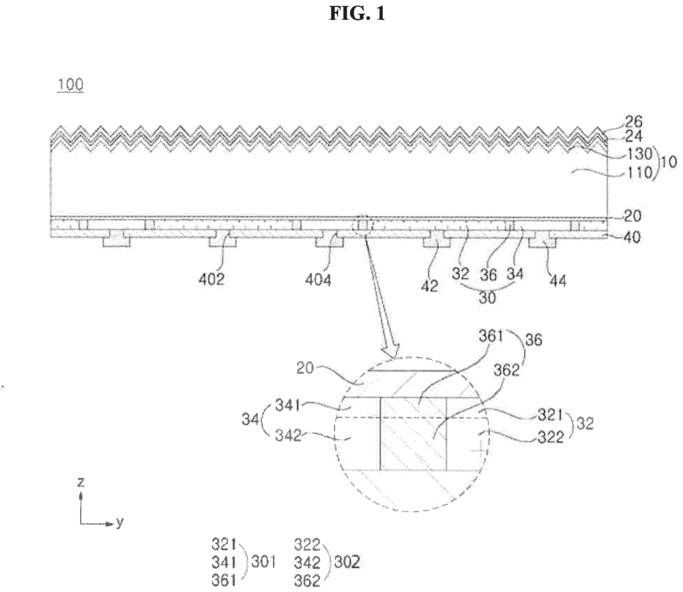

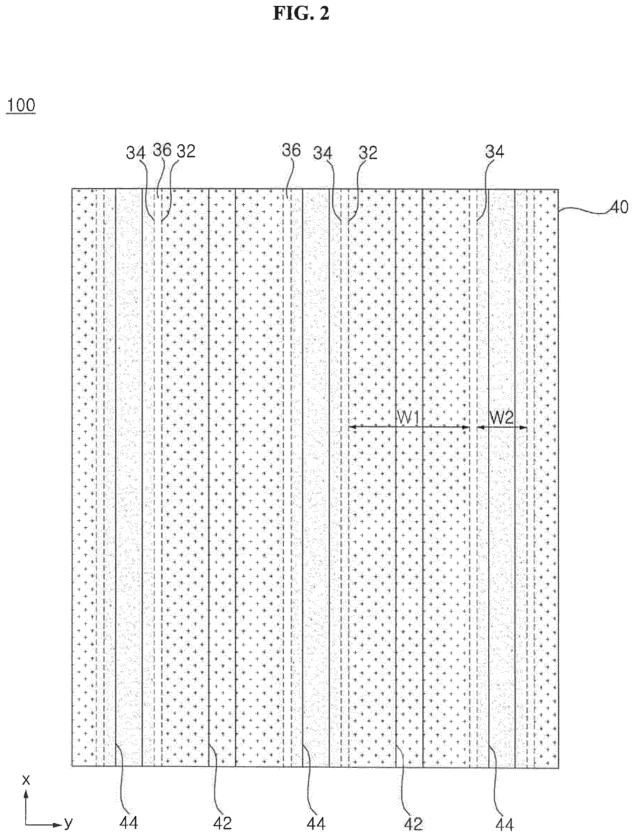

FIG. 1 is a cross-sectional view illustrating a solar cell according to an embodiment of the present invention, and FIG. 2 is a partial rear plan view of the solar cell illustrated in FIG. 1.

Referring to FIGS. 1 and 2, the solar cell 100 according to the present embodiment includes a semiconductor substrate 10 including a base area 110, a protective-film layer 20, which is formed on one surface (hereinafter, "back surface") of the semiconductor substrate 10, a first conductive area 32 and a second conductive area 34, which are located over the protective-film layer 20 and are formed of a crystalline semiconductor, the first conductive area 32 being of a first conductive type and the second conductive area 34 being of a second conductive type that is opposite to the first conductive type, and a first electrode 42 and a second electrode 44, which are respectively connected to the first conductive area 32 and the second conductive area 34. At this time, in the present embodiment, the first conductive area 32 includes a first portion 321, which is located over the protective-film layer 20 and has a first crystal grain size (e.g. a first average crystal grain size), and a second portion 322, which is located over the first portion 321 and spaced apart from the protective-film layer 20 and has a second crystal grain size (e.g. a second average crystal grain size), which is greater than the first crystal grain size. In addition, the solar cell 100 may further include, for example, passivation films 20 and 40, and an anti-reflection film 26. This will be described below in more detail.

The semiconductor substrate 10 may include the base area 110, which is doped with a first or second conductive dopant at a relatively low doping concentration, and thus is of a first or second conductive type. The base area 110 may be formed of a crystalline semiconductor including the first or second conductive dopant. In one example, the base area 110 may be formed of a monocrystalline or polycrystalline semiconductor (e.g. monocrystalline or polycrystalline silicon) including the first or second conductive dopant. In particular, the base area 110 may be formed of a monocrystalline semiconductor (e.g. a monocrystalline semiconductor wafer, and more specifically, a semiconductor silicon wafer) including the first or second conductive dopant. The solar cell, which is manufactured based on the base area 110 or the semiconductor substrate 10 having high crystallinity and thus low defects, has excellent electrical properties.

In addition, the semiconductor substrate 10 may include a front-surface field area (or a field area) 130, which is located on the other surface (hereinafter, "front surface") of the semiconductor substrate 10. The front-surface field area 130 may be of the same conductive type as the base area 110, and may have a higher doping concentration than the base area 110.

The present embodiment illustrates the instance where the front-surface field area 130 is configured as a doped area formed by doping the semiconductor substrate 10 with a first or second conductive dopant at a relatively high doping concentration. Thus, the front-surface field area 130 may include a first or second conductive crystalline (monocrystalline or polycrystalline) semiconductor and constitutes a portion of the semiconductor substrate 10. In one example, the front-surface field area 130 may configure a portion of a first or second conductive monocrystalline semiconductor substrate (e.g. a monocrystalline silicon wafer substrate).

At this time, the doping concentration of the front-surface field area 130 may be less than the doping concentration of the first or second conductive area 32 or 34, which is of the same conductive type as the front-surface field area 130. This is because the front-surface field area 130 needs a relatively low doping concentration in order to prevent carriers from moving toward the front surface of the semiconductor substrate 10 while allowing horizontal movement of the carriers. However, the embodiments of the present invention are not limited thereto.

The dopant included in the front-surface field area 130 may be of the same conductive type as the first or second conductive dopant included in the first or second conductive area 32 or 34. The dopant included in the front-surface field area 130 may be the same as or different from the first or second conductive dopant included in the second conductive area 34.

However, the embodiments of the present invention are not limited thereto. Thus, the front-surface field area 130 may be formed by doping a separate semiconductor layer (e.g. an amorphous semiconductor layer, a microcrystalline semiconductor layer, or a polycrystalline semiconductor layer), rather than the semiconductor substrate 10, with a first or second conductive dopant. Alternatively, the front-surface field area 130 may be configured as a field area, which functions similar to a layer (e.g. the front-surface passivation film 24 and/or the anti-reflection film 26), which is formed close to the semiconductor substrate 10 and is doped with a fixed charge. For example, when the base area 110 is of an n-type, the front-surface passivation film 24 may be formed of an oxide (e.g. an aluminum oxide) having a fixed negative charge so as to form an inversion layer on the surface of the base area 110, thereby being used as a field area. In this instance, the semiconductor substrate 10 may include only the base area 110 without a separate doped area, which may minimize defects of the semiconductor substrate 10. The front-surface field area 130 having various structures may be formed using various other methods.

In the present embodiment, the front surface of the semiconductor substrate 10 may be subjected to texturing so as to have protrusions having, for example, a pyramidal shape. The protrusions formed on the semiconductor substrate 10 may have a predetermined shape (e.g. a pyramidal shape) having an outer surface formed along a specific semiconductor crystalline face (e.g. (111). When the roughness of the front surface of the semiconductor substrate 10 is increased by the protrusions formed via texturing, the reflectance of light introduced through the front surface of the semiconductor substrate 10 may be reduced. Thus, the quantity of light, which reaches a pn junction formed by the base area 110 and the first or second conductive area 32 or 34, may be increased, which may minimize shading loss.

In addition, the back surface of the semiconductor substrate 10 may be formed into a relatively smooth flat surface having a lower surface roughness than the front surface via, for example, mirror surface grinding. This is because the properties of the solar cell 100 may considerably vary according to the properties of the back surface of the semiconductor substrate 10 in the instance where both the first and second conductive areas 32 and 34 are formed on the back surface of the semiconductor substrate 10 as in the present embodiment. Accordingly, the back surface of the semiconductor substrate 10 is not provided with the protrusions formed by texturing, so as to achieve improved passivation, which may consequently improve the properties of the solar cell 100. However, the embodiments of the present invention are not limited thereto. In some instances, the back surface of the semiconductor substrate 10 may be provided with protrusions formed by texturing. Various other alterations are also possible.

The protective-film layer 20 may be formed over the back surface of the semiconductor substrate 10. In one example, the protective-film layer 20 may be formed over the entire semiconductor substrate 10 so as to come into contact with the back surface of the semiconductor substrate 10, which may result in a simplified structure and improved tunneling effects. However, the embodiments of the present invention are not limited thereto.

The protective-film layer 20 serves as a barrier for electrons and holes, thereby preventing minority carriers from passing therethrough and allowing only majority carriers, which accumulate at a portion adjacent to the protective-film layer 20 and thus have a predetermined amount of energy or more, to pass therethrough. At this time, the majority carriers, which have a predetermined amount of energy or more, may easily pass through the protective-film layer 20 owing to tunneling effects. In addition, the protective-film layer 20 may serve as a diffusion barrier, which prevents the dopant of the conductive areas 32 and 34 from diffusing to the semiconductor substrate 10. The protective-film layer 20 may include various materials to enable the tunneling of the majority carriers. In one example, the protective-film layer 20 may include amorphous silicon, an oxide, a nitride, a semiconductor, and a conductive polymer. For example, the protective-film layer 20 may include a silicon oxide, a silicon nitride, a silicon oxide nitride, intrinsic amorphous silicon, or intrinsic polycrystalline silicon. In one example, the protective-film layer 20 may be formed of an insulation material, such as, for example, an oxide or a nitride, and in particular, may be configured as a silicon oxide layer including a silicon oxide. This is because the silicon oxide layer has excellent passivation and thus ensures easy tunneling of carriers.

In order to achieve sufficient tunneling effects, the protective-film layer 20 may be thinner than the back-surface passivation film 40. In one example, the thickness of the protective-film layer 20 may be 5 nm or less (more specifically, 2 nm or less, for example, within a range from 0.5 nm to 2 nm). When the thickness of the protective-film layer 20 exceeds 5 nm, smooth tunneling does not occur, and consequently, the solar cell 100 cannot operate. When the thickness of the protective-film layer 20 is below 0.5 nm, it may be difficult to form the protective-film layer 20 having a desired quality. In order to further improve tunneling effects, the thickness of the protective-film layer 20 may be 2 nm or less (more specifically, within a range from 0.5 nm to 2 nm). However, the embodiments of the present invention are not limited thereto, and the thickness of the protective-film layer 20 may have any of various values.

A semiconductor layer 30 including the conductive areas 32 and 34 may be located over the protective-film layer 20. In one example, the semiconductor layer 30 may be formed so as to come into contact with the protective-film layer 20, which may result in a simplified structure and maximized tunneling effects. However, the embodiments of the present invention are not limited thereto.

In the present embodiment, the semiconductor layer 30 may include the first conductive area 32, which includes a first conductive dopant and thus is of a first conductive type, and the second conductive area 34, which includes a second conductive dopant and thus is of a second conductive type. The first conductive area 32 and the second conductive area 34 may be located in the same plane over the protective-film layer 20. That is, no layer may be interposed between the first and second conductive areas 32 and 34 and the protective-film layer 20, or when another layer is interposed between the first and second conductive areas 32 and 34 and the protective-film layer 20, the interposed layer may have the same stack structure. In addition, a barrier area 36 may be located between the first conductive area 32 and the second conductive area 34 in the same plane as the first and second conductive areas 32 and 34.

In one example, in the present embodiment, the base area 110 may be of a second conductive type. At this time, the first conductive area 32 configures an emitter area, which forms a pn junction (or a pn tunnel junction) along with the base area 110 with the protective-film layer 20 interposed therebetween so as to produce carriers via photoelectric conversion. The second conductive area 34 configures a back-surface field area, which forms a back surface field so as to prevent the loss of carriers due to recombination on the surface of the semiconductor substrate 10 (more accurately, on the back surface of the semiconductor substrate 10).

However, the embodiments of the present invention are not limited thereto. The base area 110 may be of a first conductive type. In this instance, the second conductive area 34 configures an emitter area, which forms a pn junction (or a pn tunnel junction) along with the base area 110 with the protective-film layer 20 interposed therebetween so as to produce carriers via photoelectric conversion. The first conductive area 32 configures a back-surface field area, which forms a back surface field so as to prevent the loss of carriers due to recombination on the surface of the semiconductor substrate 10 (more accurately, on the back surface of the semiconductor substrate 10).

At this time, the first conductive area 32 may include a crystalline semiconductor (e.g. silicon) including a first conductive dopant. In addition, the second conductive area 34 may include a crystalline semiconductor (e.g. silicon) including a second conductive dopant.

In the present embodiment, each of the first and second conductive areas 32 and 34 is configured as a semiconductor layer, which is formed over the semiconductor substrate 10 (more particularly, over the protective-film layer 20) separately from the semiconductor substrate 10, and is doped with a first or second conductive dopant. For example, each of the first and second conductive areas 32 and 34 may be formed by doping a polycrystalline semiconductor layer (e.g. a polycrystalline silicon layer), which may be easily manufactured by various methods such as, for example, deposition, with a first or second conductive dopant. The first or second conductive dopant may be added to the semiconductor layer in the process of forming the semiconductor layer, or may be added to the semiconductor layer after the semiconductor layer is formed, through the use of various doping methods, such as, for example, thermal diffusion and ion implantation.

At this time, when the first or second conductive dopant is of a p-type, it may be a group-Ill element, such as boron (B), aluminum (Al), gallium (ga), or indium (In). When the first or second conductive dopant is of an n-type, it may be a group-V element, such as phosphorus (P), arsenic (As), bismuth (Bi), or antimony (Sb). In one example, the first conductive dopant may be a p-type boron (B), and the second conductive dopant may be an n-type phosphorous (P).

In addition, the barrier area 36 may be located between the first conductive area 32 and the second conductive area 34 so that the first conductive area 32 and the second conductive area 34 are spaced apart from each other. When the first conductive area 32 and the second conductive area 34 are in contact with each other, shunts may occur, undesirably causing deterioration in the performance of the solar cell 100. Therefore, in the present embodiment, unnecessary shunts may be prevented by positioning the barrier area 36 between the first conductive area 32 and the second conductive area 34.

The barrier area 36 may be formed of any of various materials, which may substantially insulate the first conductive area 32 and the second conductive area 34 from each other. That is, the barrier area 36 may be formed of an undoped insulation material (e.g. an oxide or a nitride). Alternatively, the barrier area 36 may include an intrinsic semiconductor. At this time, the first conductive area 32, the second conductive area 34, and the barrier area 36 are formed of the same semiconductor (e.g. a polycrystalline semiconductor, and more specifically, polycrystalline silicon) so that they are successively formed to come into contact with each other at the side surfaces thereof, and the barrier area 36 may be an i-type (intrinsic) semiconductor material that substantially includes no dopant. In one example, after a semiconductor layer is formed of a semiconductor material, an area of the semiconductor layer is doped with a first conductive dopant so as to form the first conductive area 32, and another area of the semiconductor layer is doped with a second conductive dopant so as to form the second conductive area 34, whereby the remaining area in which the first conductive area 32 and the second conductive area 34 are not formed may configure the barrier area 36. Thus, the method of manufacturing the first conductive area 32, the second conductive area 34, and the barrier area 36 may be simplified.

However, the embodiments of the present invention are not limited thereto. Thus, when the barrier area 36 is formed separately from the first conductive area 32 and the second conductive area 34, the barrier area 36 may have a thickness different from the first conductive area 32 and the second conductive area 34. In one example, in order to more effectively prevent a short-circuit between the first conductive area 32 and the second conductive area 34, the barrier area 36 may be thicker than the first conductive area 32 and the second conductive area 34. Alternatively, in order to reduce the amount of a raw material required to form the barrier area 36, the barrier area 36 may be thinner than the first conductive area 32 and the second conductive area 34. Of course, various other alterations are possible. In addition, the basic constituent material of the barrier area 36 may differ from those of the first conductive area 32 and the second conductive area 34.

In addition, the present embodiment illustrates the instance where the barrier area 36 causes the first conductive area 32 and the second conductive area 34 to be wholly spaced apart from each other. However, the embodiments of the present invention are not limited thereto. Thus, the barrier area 36 may be formed to cause the first conductive area 32 and the second conductive area 34 to be spaced apart from each other only along a portion of the boundary therebetween. Thereby, the conductive areas 32 and 34 may come into contact with each other along the remaining portion of the boundary therebetween.

In the present embodiment, in one example, the base area 110 may be of a second conductive type. At this time, the first conductive area 32, which is of a different conductive type from the base area 110, may be wider than the second conductive area 34, which is of the same conductive type as the base area 110. As such, the pn junction, which is formed through the protective-film layer 20 between the base area 110 and the first conductive area 32, may have an increased width. At this time, when the conductive type of the base area 110 and the second conductive area 34 is an n-type and the conductive type of the first conductive area 32 is a p-type, the wide first conductive area 32 may effectively collect holes, which move relatively slowly. However, the embodiments of the present invention are not limited thereto.

The planar structure of the first conductive area 32, the second conductive area 34, and the barrier area 36 will be described below in more detail with reference to FIG. 2.

The back-surface passivation film 40 may be formed over the first and second conductive areas 32 and 34 and the barrier area 36 on the back surface of the semiconductor substrate 10. In one example, the back-surface passivation film 40 may come into contact with the first and second conductive areas 32 and 34 and the barrier area 36, thus having a simplified structure. However, the embodiments of the present invention are not limited thereto.

The back-surface passivation film 40 has an opening 402 for connection of the first conductive area 32 and the first electrode 42 and an opening 404 for connection of the second conductive area 34 and the second electrode 44. As such, the back-surface passivation film 40 serves to prevent the first conductive area 32 and the second conductive area 34 from being connected to the incorrect electrode (i.e. the second electrode 44 in the instance of the first conductive area 32 and the first electrode 42 in the instance of the second conductive area 34). In addition, the back-surface passivation film 40 may be used for the passivation of the first and second conductive areas 32 and 34 and/or the barrier area 36.

The front-surface passivation film 24 and/or the anti-reflection film 26 may be located over the front surface of the semiconductor substrate 10 (more accurately, over the front-surface field area 130 formed on the front surface of the semiconductor substrate 10). In some embodiments, only the front-surface passivation film 24 may be formed over the semiconductor substrate 10, only the anti-reflection film 26 may be formed over the semiconductor substrate 10, or the front-surface passivation film 24 and the anti-reflection film 26 may be sequentially located over the semiconductor substrate 10. FIG. 1 illustrates the instance where the front-surface passivation film 24 and the anti-reflection film 26 are sequentially located over the semiconductor substrate 10 so as to come into contact with each other, and the semiconductor substrate 10 comes into contact with the front-surface passivation film 24. However, the embodiments of the present invention are not limited thereto, and the semiconductor substrate 10 may come into contact with the anti-reflection film 26. Various other alterations are also possible.

The back-surface passivation film 40, the front-surface passivation film 24 and/or the anti-reflection film 26 may be thicker than the protective-film layer 20. As such, insulation and passivation properties may be improved. Various other alterations are possible.

The back-surface passivation film may be formed throughout the back surface of the semiconductor substrate 10 excluding the openings 402 and 404, through which the first and second electrodes 42 and 44 pass. In addition, the front-surface passivation film 24 and the anti-reflection film 26 may substantially be formed through the front surface of the semiconductor substrate 10. Here, "formed throughout" includes not only physically complete formation, but also formation with inevitably excluded parts.

The front-surface or back-surface passivation films 24 and 40 are formed to be brought into contact with the front surface of the semiconductor substrate 10 or the first and second conductive areas 32 and 34 in order to realize the passivation of defects, which are present in the surface or the bulk of the first and second conductive areas 32 and 34. As such, the open-circuit voltage of the solar cell 100 may be increased via the removal of recombination sites of minority carriers. The anti-reflection film 26 reduces the reflectance of light introduced into the front surface of the semiconductor substrate 10. Thus, the quantity of light, which reaches the pn junction formed by the base area 110 and the first or second conductive area 32 or 34, may be increased. Thereby, the short-circuit current Isc of the solar cell 100 may be increased. In this way, the front-surface or back-surface passivation film 24 or 40 and the anti-reflection film 26 may increase the open-circuit voltage and the short-circuit current of the solar cell 100, thereby improving the efficiency of the solar cell 100.

The back-surface passivation film 40, the front-surface passivation film 24 and/or the anti-reflection film 26 may be formed of various materials. In one example, the back-surface passivation film 40, the front-surface passivation film 24 and/or the anti-reflection film 26 may be formed of a single film or multiple films in the form of a combination of two or more films selected from the group consisting of a silicon nitride film, a silicon nitride film containing hydrogen, a silicon oxide film, a silicon oxide nitride film, an aluminum oxide film, a silicon carbide film, and MgF₂, ZnS, TiO₂, and CeO₂ films. In one example, the front-surface passivation film 24 may be a silicon oxide film formed over the semiconductor substrate 10, and the anti-reflection film 26 may have a structure in which a silicon nitride film and a silicon carbide film are sequentially stacked one above another. In addition, in one example, the back-surface passivation film 40 may have a structure in which a silicon nitride film and a silicon carbide film are sequentially stacked one above another. However, the embodiments of the present invention are not limited thereto, and the back-surface passivation film 40 may of course include various materials.

In one example, in the present embodiment, the front-surface passivation film 24, the back-surface passivation film 40, and/or the anti-reflection film 26 may include no dopant or the like, in order to achieve excellent insulation and passivation properties.

The electrodes 42 and 44, disposed on the back surface of the semiconductor substrate 10, include the first electrode 42, which is electrically and physically connected to the first conductive area 32, and the second electrode 44, which is electrically and physically connected to the second conductive area 34.

At this time, the first electrode 42 is connected to the first conductive area 32 through the opening 402 in the back-surface passivation film 40, and the second electrode 44 is connected to the second conductive area 34 through the opening 404 in the back-surface passivation film 40. The first and second electrodes 42 and 44 may include various metal materials. In one example, the first and second electrodes 42 and 44 may be formed of metals, and may be formed to come into contact with the first and second conductive areas 32 and 34 respectively.

Hereinafter, the plan shape of the first conductive area 32, the second conductive area 34, the barrier area 36, and the first and second electrodes 42 and 44 will be described in detail with reference to FIGS. 1 and 2.

Referring to FIGS. 1 and 2, in the present embodiment, the first conductive area 32 and the second conductive area 34 extend a long length to form stripes and are alternately arranged in the direction crossing the longitudinal direction thereof. The barrier area 36 may be located, as a spacer, between the first conductive area 32 and the second conductive area 34. Although not illustrated in FIGS. 1 and 2, a plurality of first conductive areas 32, which are spaced apart from one another, may be interconnected at one edge thereof, and a plurality of second conductive areas 34, which are spaced apart from one another, may be interconnected at the other edge thereof. However, the embodiments of the present invention are not limited thereto.

At this time, the first conductive area 32 may be wider than the second conductive area 34. In one example, the areas of the first conductive area 32 and the second conductive area 34 may be adjusted by providing the first and second conductive areas 32 and 34 with different widths. That is, the width W1 of the first conductive area 32 may be greater than the width W2 of the second conductive area 34. This illustrates the instance where the first conductive area 32 functions as an emitter area. When the second conductive area 34 functions as an emitter area, the second conductive area 34 may be larger or wider than the first conductive area 32.

In addition, the first electrode 42 may be formed in a stripe shape so as to correspond to the first conductive area 32, and the second electrode 44 may be formed in a stripe shape so as to correspond to the second conductive area 34. The respective openings (see reference numerals 402 and 404 in FIG. 1) may be formed along the entire length of the first and second electrodes 42 and 44 so as to correspond to the first and second electrodes 42 and 44. Thus, the contact area between the first and second electrodes 42 and 44 and the first and second conductive areas 32 and 34 may be maximized, which may increase the efficiency of collection of carriers. However, the embodiments of the present invention are not limited thereto. The opening 402 and 404 may of course be formed to connect only a portion of the first and second electrodes 42 and 44 to each of the first conductive area 32 and the second conductive area 34. For example, the opening 402 and 404 may be formed as a plurality of contact holes. In addition, although not illustrated in FIGS. 1 and 2, the first electrodes 42 may be interconnected at one edge thereof, and the second electrodes 44 may be interconnected at the other edge thereof. However, the embodiments of the present invention are not limited thereto.

When light is introduced into the solar cell 100 according to the present embodiment, electrons and holes are produced via photoelectric conversion at the pn junction formed between the base area 110 and the first conductive area 32, and the produced electrons and holes move to the first conductive area 32 and the second conductive area 34 via tunneling through the protective-film layer 20, and thereafter move to the first and second electrodes 42 and 44. Thereby, electricity is generated.

In the solar cell 100 having a back-surface electrode structure in which the electrodes 42 and 44 are formed on the back surface of the semiconductor substrate 10 and no electrode is formed on the front surface of the semiconductor substrate 10, shading loss may be minimized on the front surface of the semiconductor substrate 10. Thus, the efficiency of the solar cell 100 may be improved.

In addition, because the first and second conductive areas 32 and 34 are formed over the semiconductor substrate 10 with the protective-film layer 20 interposed therebetween, the first and second conductive areas 32 and 34 are formed separately from the semiconductor substrate 10. As such, loss due to recombination may be less than that when a doped area formed by doping an area of the semiconductor substrate 10 with a dopant is used as a conductive area.

In the present embodiment, the first conductive area 32 includes the first portion 321, which is located over the protective-film layer 20 and has a first crystal grain size, and the second portion 322, which is located over the first portion 321 and spaced apart from the protective-film layer 20 and has a second crystal grain size, which is greater than the first crystal grain size. Here, the crystal grain size may mean an average crystal grain size. In addition, in the present embodiment, the second conductive area 34 includes a first portion 341, which is located over the protective-film layer 20 and has a first crystal grain size, and a second portion 342, which is located over the first portion 341 and spaced apart from the protective-film layer 20 and has a second crystal grain size, which is greater than the first crystal grain size. Likewise, the barrier area 36 includes a first portion 361, which is located over the protective-film layer 20 and has a first crystal grain size, and a second portion 362, which is located over the first portion 341 and spaced apart from the protective-film layer 20 and has a second crystal grain size, which is greater than the first crystal grain size. That is, in the present embodiment, a first portion 301 of the semiconductor layer 30 may include the first portion 321 of the first conductive area 32, the first portion 341 of the second conductive area 34, and the first portion 361 of the barrier area 36, and a second portion 302 of the semiconductor layer 30 may include the second portion 322 of the first conductive area 32, the second portion 342 of the second conductive area 34, and the second portion 362 of the barrier area 36.

When the second portions 322 and 342 of the first and second conductive areas 32 and 34 have a crystal grain size greater than the first portions 321 and 341 located over the protective-film layer 20, a large amount of dopant may be located in the second portions 322 and 342 because the diffusion rate of a dopant through the second portions 322 and 342 is low, and a relatively small amount of dopant is located in the first portions 321 and 341 compared to the second portions 322 and 342. Thus, because a relatively large amount of dopant may be located in the second portions 332 and 342 of the first and second conductive areas 32 and 34, which are located close to (e.g. in contact with) the electrodes 42 and 44, the surface concentration of the first and second conductive areas 32 and 34 may be increased, and consequently, the contact resistance between the first and second conductive areas 32 and 34 and the electrodes 42 and 44 may be reduced. In addition, because a relatively small amount of dopant is located in the first portions 321 and 341 of the first and second conductive areas 32 and 34, which are close to the protective-film layer 20, the amount of dopant to diffuse to the protective-film layer 20 or nearby portions of the semiconductor substrate 10 may be reduced, and excellent passivation properties may be maintained.

On the other hand, when the entire portion of the first and second conductive areas 32 and 34 has substantially the same crystal grain size, it may be difficult to improve all of the contact resistance, passivation properties, and carrier mobility by adjusting a doping profile. For example, when the first and second conductive areas 32 and 34 include only the first portions 321 and 341, having a relatively small first crystal grain size, without the second portions 322 and 342, a grain boundary may be large, and thus the carrier mobility may not be high. In another example, when the first and second conductive areas 32 and 34 include only the second portions 322 and 342, having a relatively large second crystal grain size, without the first portions 321 and 341, the diffusion rate of a dopant may be reduced and it may be difficult for the first and second conductive areas 32 and 34 to be doped with a sufficient concentration. Thereby, the contact resistance between the first and second conductive areas 32 and 34 and the electrodes 42 and 44 may be increased. In addition, when the amount of dopant is increased, which is another method to increase carrier mobility, an excessive amount of dopant may diffuse to the protective-film layer 20 or to nearby portions of the semiconductor substrate 10, thus causing deterioration in passivation.

In one example, the first crystal grain size of the first portion 301 may range from 10 nm to 1 µm and the second crystal grain size of the second portion 302, which is greater than the first crystal grain size, may range from 20 nm to 600 µm. At this time, the first or second crystal grain size may be the larger one of the average crystal grain size when viewed in the thickness direction and the average crystal grain size when viewed in plan. When the first crystal grain size is below 10 nm, a dopant may easily diffuse through the first portion 321, causing deterioration in passivation at the interface of the protective-film layer 20 and it may be difficult to form the first portion 321 having such a crystal grain size. On the other hand, when the first crystal grain size is above 1 µm, a dopant may not sufficiently diffuse to the first portion 321, causing an increase in resistance. When the second crystal grain size is below 20 nm, this may be too small in comparison with the crystal grain size of the first portion 301, and therefore it may be difficult to realize the above-described effects of the first portion 301 and the second portion 302. When the second crystal grain size exceeds 600 µm, it may be difficult to form the first and second conductive areas 32 and 34 having a desired doping concentration and the process of forming the first and second conductive areas 32 and 34 may be somewhat difficult because almost no dopant may diffuse.

More specifically, the first crystal grain size of the first portion 301 may range from 20 nm to 50 nm and the second crystal grain size of the second portion 302 may range from 200 nm to 500 nm (e.g. 200 nm to 300 nm). With these first and second crystal grain sizes, the above-described effects of the first portion 301 and the second portion 302 may be effectively realized.

Alternatively, a difference between the crystal grain size of the first portion 301 and the crystal grain size of the second portion 302 may range from 10 nm to 600 µm. When the difference between the crystal grain sizes is below 10 nm, the above-described effects of the first portion 301 and the second portion 302 may not be sufficient. It may be difficult to form the second portion 302 so that the difference between the crystal grain sizes exceeds 600 µm. More specifically, the difference between the crystal grain size of the first portion 301 and the crystal grain size of the second portion 302 may range from 10 nm to 500 nm (e.g. 100 nm to 300 nm). Within this range, the above-described effects of the first portion 301 and the second portion 302 may be effectively realized.

Alternatively, the ratio of the first crystal grain size of the first portion 301 to the second crystal grain size of the second portion 302 may range from 1:1.5 to 1:100 (e.g. 1:2 to 1:40, and in one example, 1:6 to 1:20). When the aforementioned ratio is below 1:1.5, the above-described effects obtained by the first portion 301 and the second portion 302 may not be sufficient. The aforementioned ratio may be difficult to set greater than 1:100 due to processing properties, and the ratio of 1:100 may make it difficult for the first and second conductive areas 32 and 34 to have the desired doping concentration. When the aforementioned ratio ranges from 1:2 to 1:40, the first portion 301 and the second portion 302 may sufficiently realize the effects attributable to the difference between the crystal grain sizes and may be easily formed in the corresponding process. In addition, when the aforementioned ratio ranges from 1:6 to 1:20, the effects attributable to the difference between the crystal grain sizes may be maximized and easy manufacture may be ensured due to processing properties.

However, the embodiments of the present invention are not limited to the above-described numerical ranges, and various other alterations are possible.

In the present embodiment, the first and second conductive areas 32 and 34 may include the first portions 321 and 341, which are formed in contact with the protective-film layer 20, and the second portions 322 and 342, which are formed in contact with the electrodes 42 and 44. Because the first and second conductive areas 32 and 34 include only two layers including the first and second portions 321 and 341 and 322 and 342, the structure of the first and second conductive areas 32 and 34 may be simplified. However, the embodiments of the present invention are not limited thereto, and the first and second conductive areas 32 and 34 may further include another layer excluding the first and second portions 321 and 341 and 322 and 342.

The thickness of the second portion 322 or 342 (or the second portion 302) relative to the thickness of the entire first or second conductive area 32 or 34 may range from 20% to 90%. When the relative thickness of the second portion is below 20%, the thickness of the second portion 322 or 342 may not be sufficient and there may be a limitation on a reduction in the contact resistance between the first or second conductive area 32 or 34 and the electrode 42 or 44. On the other hand, when the relative thickness of the second portion exceeds 90%, the thickness of the first portion 321 or 342 is too small to achieve sufficient doping, and thus the first or second conductive area 32 or 34 may have high resistance in a portion thereof that is in contact with the protective-film layer 20.

In one example, the thickness of the second portion 322 or 342 may be equal to or greater than the thickness of the first portion 321 or 341. In particular, the thickness of the second portion 322 or 342 may be greater than the thickness of the first portion 321 or 341. Thus, the thickness of the second portion 322 or 342 relative to the thickness of the entire first or second conductive area 32 or 34 may range from 50% to 90% (more specifically, may be greater than 50% and equal to or less than 90%). This is because carrier mobility may be increased and electrical properties may be improved when the relative thickness of the second portion 322 or 342 is increased.

In the present embodiment, the barrier area 36 may include the first portion 361 and the second portion 362, and the first portion 361 having a smaller crystal grain size may be located close to or in contact with the protective-film layer 20. Thus, although the portion of the barrier 36 close to the protective-film layer 20 is a portion having high carrier mobility, it may effectively prevent carriers from moving from the side surfaces of the first and second conductive areas 32 and 34 by way of the barrier area 36 in the corresponding portion. The barrier area 36 including the first portion 361 and the second portion 362 may be easily formed by undoping a portion of the semiconductor layer 30 when the first and second conductive areas 32 and 34 are formed by doping the semiconductor layer 30. However, the embodiments of the present invention are not limited thereto, and the barrier area 36 including the first portion 361 and the second portion 362 may be formed via various methods.

The present specification discloses the instance where the first portion 321 of the first conductive area 32, the first portion 341 of the second conductive area 34, and the first portion 361 of the barrier area 36, which constitute the first portion 301, have the same first crystal grain size, and the second portion 322 of the first conductive area 32, the second portion 342 of the second conductive area 34, and the second portion 362 of the barrier area 36, which constitute the second portion 302, have the same second crystal grain size. This is because the first conductive area 32, the second conductive area 34 and the barrier area 36 are included in the semiconductor layer 30 that is successively formed in the same process, and therefore, the crystal grain size is determined from the average crystal grain size of the entire portion. However, the embodiments of the present invention are not limited thereto. Thus, the first portion 321 of the first conductive area 32, the first portion 341 of the second conductive area 34, and the first portion 361 of the barrier area 36 may have different crystal grain sizes, and the second portion 322 of the first conductive area 32, the second portion 342 of the second conductive area 34, and the second portion 362 of the barrier area 36 may have different crystal grain sizes. Even in this instance, the second portion 322 of the first conductive area 32 may have a crystal grain size greater than the first portion 321, the second portion 342 of the second conductive area 34 may have a crystal grain size greater than the first portion 341, and the second portion 362 of the barrier area 36 may have a crystal grain size greater than the first portion 361.

The first and second conductive areas 32 and 34 and/or the barrier area 36 having the above-described structures may be formed via various methods.

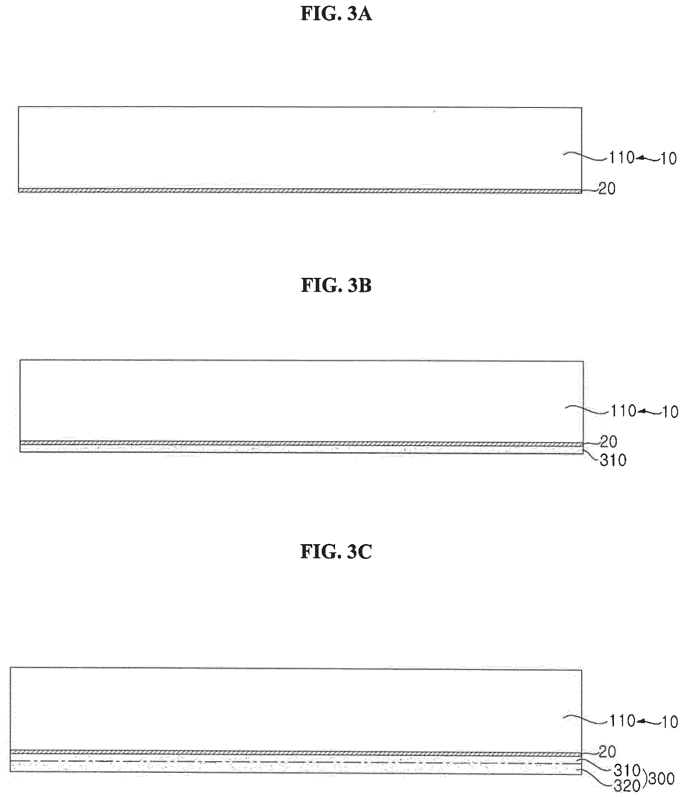

In one example, when forming the first and second conductive areas 32 and 34 of the semiconductor layer 30, a semiconductor layer including a first semiconductor portion (see reference numeral 310 in FIG. 3B), all of which has a first crystal grain size, may be formed, and thereafter a second semiconductor portion (see reference numeral 320 in FIG. 3C), which has a second crystal grain size, may be formed. Doping may be performed in the process of forming the semiconductor layer 30, or may be performed via a separate doping process. This will be described later in more detail with reference to FIGS. 3A to 3G.

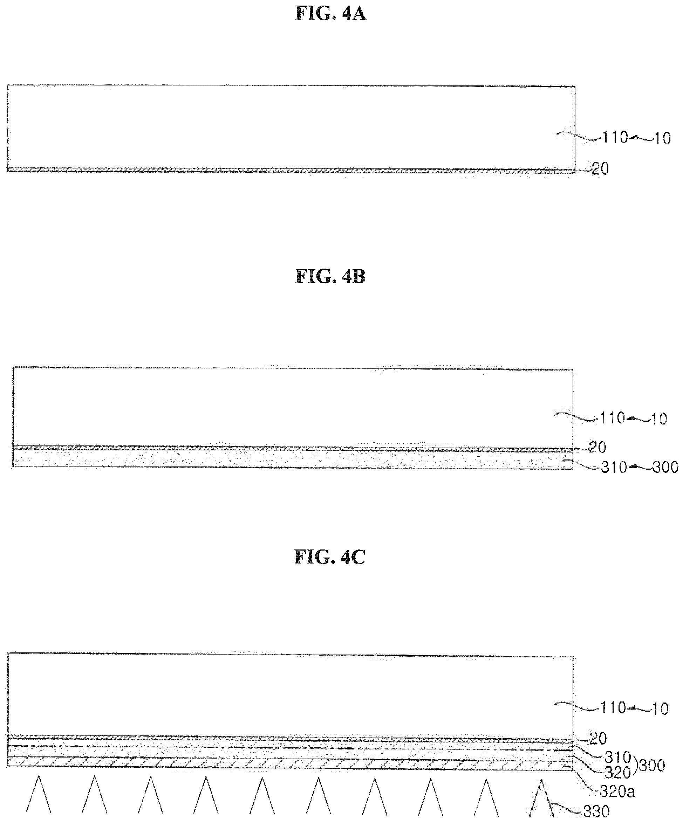

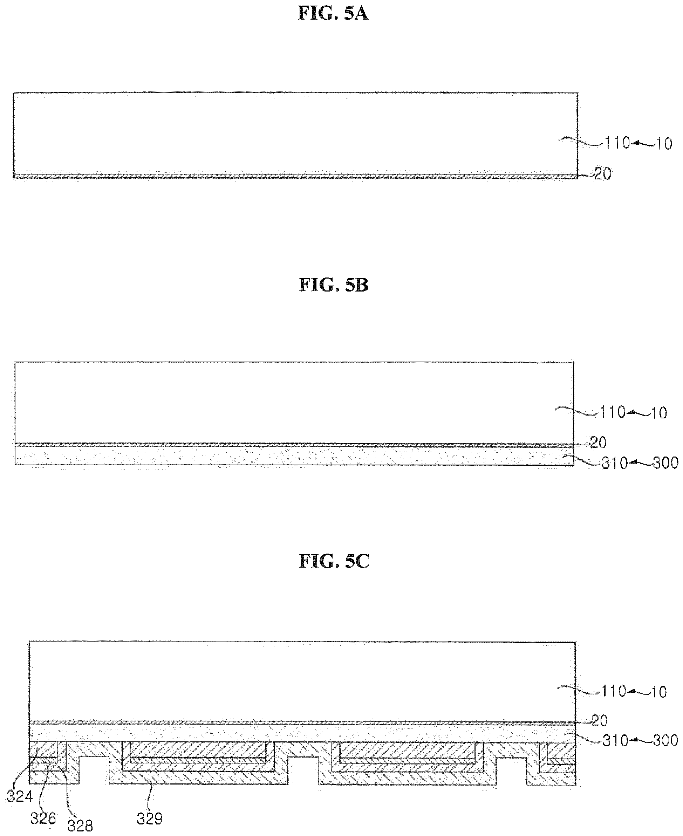

Alternatively, after a semiconductor layer including a first semiconductor portion (see reference numeral 310 in FIG. 4B or FIG. 5B), which uniformly has a first crystal grain size, is formed, a portion of the semiconductor layer is irradiated with a laser to form a second semiconductor portion disposed on the first semiconductor portion. Specifically, a portion of the first semiconductor portion 310 in the thickness direction is locally subjected to thermal treatment so that the second semiconductor portion (see reference numeral 320 in FIG. 4C), which has a second crystal grain size, may be formed on the first portion 310. This will be described later in more detail with reference to FIGS. 4A to 4C and FIGS. 5A to 5D.

FIGS. 3A to 3G are cross-sectional views illustrating a method of manufacturing a solar cell according to an embodiment of the present invention.

First, as illustrated in FIG. 3A, the protective-film layer 20 is formed over the semiconductor substrate 10 including the base area 110. The protective-film layer 20 may be formed via any of various methods, such as, for example, chemical oxidation, thermal oxidation, or deposition.

Subsequently, as illustrated in FIGS. 3B and 3C, a semiconductor layer 300, which has a crystalline structure and is intrinsic, is formed over the semiconductor substrate 10 (more accurately, over the protective-film layer 20 formed over the semiconductor substrate 10).

At this time, in the present embodiment, as illustrated in FIG. 3B, a semiconductor layer including the first semiconductor portion 310, which has a first crystal grain size, may be formed over the protective-film layer 20 under a first process condition. Thereafter, as illustrated in FIG. 3C, the second semiconductor portion 320, which has a second crystal grain size, may be formed over the first semiconductor portion 310 under a second process condition, which differs from the first process condition. Thereby, the semiconductor layer 300 including the first semiconductor portion 310 and the second semiconductor portion 320, which have different crystal grain sizes, may be formed.

At this time, the step of forming the first semiconductor portion 310 and the step of forming the second semiconductor portion 320 may be performed as in-situ processes, which are successively performed in the same equipment merely by changing process conditions. This may simplify the manufacturing process. In addition, when the semiconductor substrate is pulled out of the equipment during the process of forming the first semiconductor portion 310 and the process of forming the second semiconductor portion 320, the semiconductor layer 300 may be contaminated or oxidized by a foreign substance, thus causing an oxide layer to be formed between the first semiconductor portion 310 and the second semiconductor portion 320. In the present embodiment, because the first semiconductor portion 310 and the second semiconductor portion 320, which have different crystal grain sizes, are successively formed in the same equipment, any problem that may occur when the semiconductor layer 300 is exposed to the outside during the formation process thereof may be prevented.

In one example, in the present embodiment, the intrinsic semiconductor layer 300 may be formed via low-pressure chemical vapor deposition. That is, gas (e.g. silane gas) including a semiconductor material, which constitutes the semiconductor layer 300, may be included. In the present embodiment, because the semiconductor layer 300 is deposited to exhibit its intrinsic properties, a gas atmosphere may include only gas including a semiconductor material. Thus, the gas to be supplied may be simplified and the purity of the semiconductor layer 300 that is formed may be improved. However, the embodiments of the present invention are not limited thereto, and another gas may be further used in order to facilitate the deposition of the semiconductor layer 300 or to improve the properties of the semiconductor layer 300. In addition, when a first conductive dopant and a second conductive dopant are doped together in the deposition process of the semiconductor layer 300, gas including the first or second conductive dopant (e.g. B2H6 or PH3) may be further included.

At this time, the first semiconductor portion 310 and the second semiconductor portion 320 may have different crystal grain sizes attributable to different processing temperatures thereof. In one example, the processing temperature in the process of forming the second semiconductor portion 320 may be higher than the processing temperature in the process of forming the first semiconductor portion 310. The high processing temperature may facilitate the growth of crystal grains in the second semiconductor portion 320, thus causing the second semiconductor layer 320 to have a relatively large second crystal grain size. In one example, the processing temperature in the process of forming the second semiconductor portion 320 may be about 10°C to 300°C higher than the processing temperature in the process of forming the first semiconductor portion 310. When the temperature difference is below 10°C, differentiating the crystal grain sizes may be limited due to the insufficient temperature difference. In addition, when the temperature difference exceeds 300°C, for example, the time and cost taken to change the temperature are increased and the properties of the first or second semiconductor portion 310 or 320 may be deteriorated.

Alternatively, the first semiconductor portion 310 and the second semiconductor portion 320 may be made to have different crystal grain sizes by differentiating, for example, the amount and kind of raw material gas that is used. In one example, the amount of gas including a semiconductor material in the process of forming the second semiconductor portion 320 may be greater than the amount of gas including a semiconductor material in the process of forming the first semiconductor portion 310. Thus, the relatively large amount of gas including a semiconductor material may facilitate the growth of crystal grains in the second semiconductor portion 320, thus causing the second semiconductor portion 320 to have a relatively large second crystal grain size. Alternatively, the second crystal grain size of the second semiconductor portion 320 may be increased by additionally introducing, for example, another gas including a semiconductor material, in addition to the raw material gas.

FIGS. 3A to 3C illustrate the instance where the protective-film layer 20 and/or the semiconductor layer 300 are formed only on the back surface of the semiconductor substrate 10. However, in practice, the protective-film layer 20 and/or the semiconductor layer 300 may also be formed on the front surface and/or the side surface of the semiconductor substrate 10, and the protective-film layer 20 and/or the semiconductor layer 300 formed on the front surface and/or the side surface may be removed in a following process.

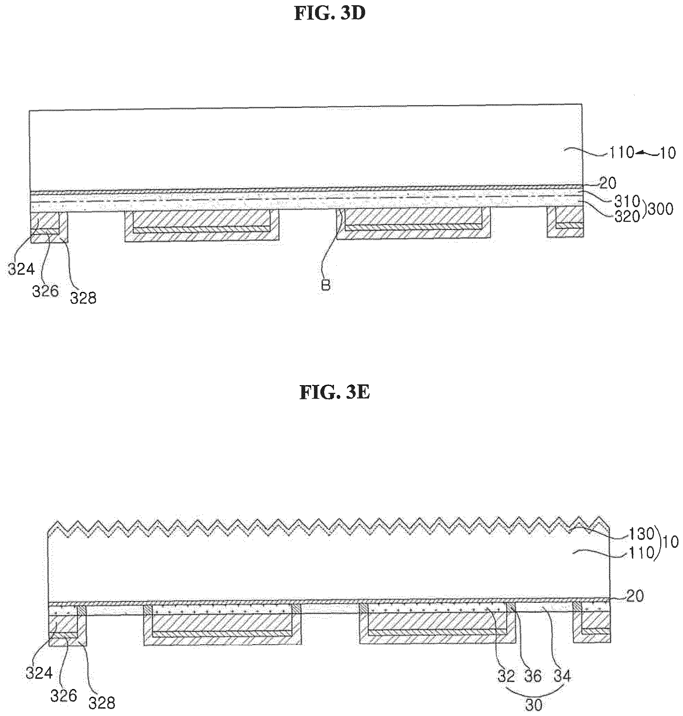

Subsequently, as illustrated in FIG. 3D, a first doping layer 324 and a mask layer 328 may be formed over the semiconductor layer 300. In addition, an undoped layer 326 may be formed between the first doping layer 324 and the mask layer 328, and may have the same shape as the first doping layer 324 and the mask layer 328.

The first doping layer 324 may include a first conductive dopant and may have a pattern corresponding to the first conductive area 32. At this time, the undoped layer 326, which has the same pattern as the first doping layer 324, may be disposed over the first doping layer 324. The first doping layer 324 and the undoped layer 326 are first wholly formed and then patterned. In one example, required portions of the first doping layer 324 and the undoped layer 326 may be removed via etching using an etching paste or an etching mask. However, the embodiments of the present invention are not limited thereto, and the first doping layer 324 and the undoped layer 326 each having a pattern may be formed.

The first doping layer 324 includes a first conductive dopant and serves to supply the first conductive dopant to the semiconductor layer 300 via diffusion in a doping process (this process is illustrated in FIG. 3E). The undoped layer 326 serves to prevent the outward diffusion of a first conductive dopant included in a first doping layer 322 in the doping process.

The first doping layer 324 may be formed of any of various materials including the first conductive dopant. In addition, the undoped layer 326 may be formed of any of various materials including no first and second conductive dopants. In one example, the first doping layer 324 may include boron silicate glass (BSG), and the undoped layer 326 may include undoped silicate glass (USG). However, the embodiments of the present invention are not limited thereto, and the first doping layer 324 and the undoped layer 326 may include various other materials. In one example, when the first doping layer 324 is of an n-type, the first doping layer 324 may include phosphorous silicate glass (PSG).

The first doping layer 324 and the undoped layer 326 may be formed via various methods, such as, for example, deposition. At this time, in the present embodiment, the first doping layer 324 and the undoped layer 326 may be formed via in-situ processes, which are successively performed in the same equipment. When the first doping layer 324 is formed of boron silicate glass and the undoped layer 326 is formed of undoped silicate glass as described above, deposition is performed to form the first doping layer 324 in the state in which gas including the first conductive dopant is supplied, and after which the supply of the gas including the first conductive dopant is interrupted so as to form the undoped layer 326. Through this change in gas, the first doping layer 324 and the undoped layer 326 may be successively formed, resulting in a simplified process.

FIG. 3D illustrates the instance where the first doping layer 324 corresponding to the first conductive area 32 is formed and the mask layer 328 is formed above the first doping layer 324. Thus, in the present embodiment, when the second conductive area 34 and the front-surface field area 130 are of the same second conductive type, the second conductive area 34 and the front-surface field area 130 may be formed together by thermally diffusing a second conductive dopant. However, the embodiments of the present invention are not limited thereto. Thus, the second conductive area 34 and the front-surface field area 130 may be formed via other methods. Alternatively, a second doping layer corresponding to the second conductive area 34 may be formed and the mask layer 328 may be formed over the second doping layer. Various other alterations are possible.

The mask layer 328 serves to prevent the dopant from diffusing to the portion on which the mask layer 328 is formed. The mask layer 328 may be formed of any of various undoped materials, which may include no first and second conductive dopants and may prevent diffusion of a dopant. In one example, the mask layer 328 may be formed of a silicon carbide (SiC) film. The silicon carbide film may effectively prevent the diffusion of a dopant. In addition, the silicon carbide film may be easily processed to have a desired shape using a laser, and may be easily removed by an etching solution (e.g. an acid solution, for example, diluted hydrofluoric acid (HF)) after the doping process.

The mask layer 328 may be formed to cover the first doping layer 324 and the undoped layer 326 and to expose a portion corresponding to the second conductive area 34. The mask layer 328 may be patterned to have a desired pattern after it is formed throughout the first doping layer 324, the undoped layer 326, and the back surface of the semiconductor substrate 10. In one example, a desired portion of the mask layer 328 may be removed via laser ablation. When the mask layer 328 is patterned using a laser, an opening corresponding to the portion, on which the second conductive area 34 will be formed, may be formed to have a desired width and interval. However, the embodiments of the present invention are not limited thereto, and the mask layer 328 may be formed such that a pattern has already been formed.

In the present embodiment, the mask layer 328 may include a barrier portion B, which is provided around the first doping layer 324 and the undoped layer 326 so as to cover a portion of the opening formed in the first doping layer 324 and the undoped layer 326. In one example, the barrier portion B may be formed on the edge of the opening formed in the first doping layer 324 so as to extend along the edge of the first doping layer 324. Thus, the area of the opening in the mask layer 328 may be smaller than the area of the opening in the first doping layer 324 and the undoped layer 326. The barrier portion B is used to form the barrier area (see reference numeral 36 in FIG. 3E). However, the embodiments of the present invention are not limited thereto. Thus, the opening in the mask layer 328 may have the same shape and the same area as the opening in the first doping layer 324 and the undoped layer 326, and no barrier portion B may be provided.

Subsequently, as illustrated in FIG. 3E, the semiconductor layer 30 including the first and second conductive areas 32 and 34 is formed by diffusing dopants to the semiconductor layer (see reference numeral 300 in FIG. 3D). In one example, thermal treatment may be performed under a gas atmosphere including a second conductive dopant. The gas atmosphere may be created using various gases including the second conductive dopant. At this time, as illustrated in the enlarged circle of FIG. 1, the semiconductor layer 30 includes a first portion (see reference numeral 301 in FIG. 1) and a second portion (see reference numeral 302 in FIG. 1). In FIGS. 3E to 3G, for brief illustration, the first portion 301 and the second portion 302 are not illustrated.

More specifically, a first conductive dopant located in the first doping layer 324 diffuses to the semiconductor layer 300, thereby forming the first conductive area 32. In addition, a second conductive dopant diffuses to the semiconductor layer 300 through the opening in the mask layer 328 from the back surface side of the semiconductor substrate 10 via thermal diffusion, thereby forming the second conductive area 34.

Accordingly, in the present embodiment, the first conductive area 32 is formed by doping the first conductive dopant using the first doping layer 324, and the second conductive area 34 is formed via thermal diffusion of the second conductive dopant using the gas including the second conductive dopant. Thereby, the first and second conductive areas 32 and 34 may be formed via a simplified process.

In addition, because the first conductive dopant and the second conductive dopant do not diffuse to a portion of the semiconductor layer 300 corresponding to the barrier portion B, the barrier area 36, which is formed of an intrinsic crystalline semiconductor, is located in the corresponding portion. Thereby, the semiconductor layer 30 including the barrier area 36 may be formed via a simplified process.

Although the present embodiment illustrates the instance where the second conductive area is formed via the thermal diffusion of the second conductive dopant, the embodiments of the present invention are not limited thereto.

In another example, after the mask layer 328 is formed, at least the opening in the mask layer 328 may be filled with a second doping layer (not illustrated) including a second conductive dopant. In one example, the second doping layer may be formed throughout the semiconductor layer 300 and the mask layer 328. In addition, the second doping layer may be formed of phosphorous silicate glass via plasma chemical vapor deposition. In this instance, thermal treatment causes the second conductive dopant included in the second doping layer to diffuse to the semiconductor layer 300 so as to form the second conductive area 34.

At this time, the front surface of the semiconductor substrate 10 may be subjected to texturing so as to form the front-surface field area 130. In one example, after the front surface of the semiconductor substrate 10 is subjected to texturing, thermal treatment to thermally diffuse the second conductive dopant may be performed so that the front-surface field area 130 and the second conductive area 34 are formed together. Alternatively, after the first and second conductive areas 32 and 34 are formed, the front surface of the semiconductor substrate 10 is subjected to texturing and then is doped with the second conductive dopant so as to form the front-surface field area 130. In this instance, the front-surface field area 130 may be formed via a process that is different from the doping process of the second conductive area 34 so as to precisely control the doping profile of the front-surface field area 130. At this time, when, for example, the protective-film layer 20 and the semiconductor layer 300 are also formed on the front surface of the semiconductor substrate 10, these layers may be removed during texturing.

Texturing on the front surface of the semiconductor substrate 10 may be performed via various methods. For example, texturing may be performed by dipping only a front-surface portion of the semiconductor substrate 10 in an alkali solution (e.g. a KOH solution). This process may advantageously reduce the processing time. Alternatively, only the front surface of the semiconductor substrate 10 may be subjected to texturing via, for example, reactive ion etching (RIE), which is a single-sided etching method. Through reactive ion etching, only a single surface may be easily etched and a texturing structure having uniform protrusions may be formed. However, the embodiments of the present invention are not limited thereto.

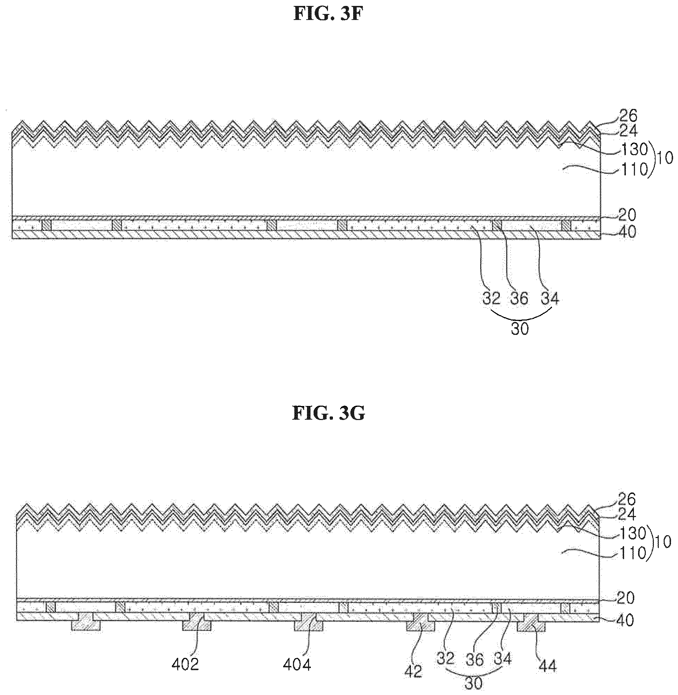

Subsequently, as illustrated in FIG. 3F, the first doping layer 324, the undoped layer 326, and the mask layer 328 are removed, the front-surface passivation film 24 and the anti-reflection film 26 are formed over the front surface of the semiconductor substrate 10, and the back-surface passivation film 40 is formed over the other surface of the semiconductor substrate 10 (more accurately, over the semiconductor layer 30 including the conductive areas 32 and 34).

The front-surface passivation film 24, the anti-reflection film 26 and/or the back-surface passivation film 40 may be formed via various methods, such as, for example, vacuum deposition, chemical vapor deposition, spin coating, screen printing, or spray coating. In addition, after the first doping layer 324, the undoped layer 326, and the mask layer 328 are removed, the front-surface passivation film 24, the anti-reflection film 26 and/or the back-surface passivation film 40 may be formed. Alternatively, the front-surface passivation film 24 and the anti-reflection film 26 may be formed before the removal of the first doping layer 324, the undoped layer 326, and the mask layer 328, and then, after the first doping layer 324, the undoped layer 326, and the mask layer 328 are removed, the back-surface passivation film 40 may be formed. Thus, the front-surface passivation film 24 and the anti-reflection film 26 may serve as a mask when the first doping layer 324, the undoped layer 326, and the mask layer 328 are removed, thereby preventing damage to the front surface of the semiconductor substrate 10 or deterioration in properties thereof.

Subsequently, as illustrated in FIG. 3G, the first and second electrodes 42 and 44, which are respectively connected to the first and second conductive areas 32 and 34, are formed.

In one example, after the opening 402 and 404 are formed in the back-surface passivation film 40, an electrode layer may be formed over the back-surface passivation film 40 so that the openings 402 and 404 are filled with the electrode layer, thereby forming the first and second electrodes 42 and 44. The electrode layer may be formed via any of various methods, such as, for example, plating or deposition. At this time, the electrode layer may be completely formed and then patterned, or the patterned electrode layer may be formed. The patterning of the electrode layer may be performed via any of various known methods.

Alternatively, after paste for the formation of the first electrode and paste for the formation of the second electrode are respectively applied on the back-surface passivation film 40 via, for example, screen printing, fire-through phenomenon or laser firing contact may be used in order to form the first and second electrodes 42 and 44 having the above-described shape. In this instance, because the openings 402 and 404 are formed during the firing process, no process of forming the openings 402 and 404 is added.

According to the present embodiment, the solar cell 100 having excellent effects may be manufactured via a simplified process and both the efficiency and productivity of the solar cell 100 may be improved. More specifically, the first and second conductive areas 32 and 34 each including the first portion 321 or 341 and the second portion 322 or 342 may be formed by simply differentiating process conditions. Because the first portion 321 or 341 and the second portion 322 or 342 may be formed via in-situ processes that are successively performed in the same equipment, the process may be effectively simplified.

Hereinafter, a method of manufacturing a solar cell according to another embodiment of the present invention will be described in detail with reference to FIGS. 4A to 4C. A detailed description of the same or extremely similar parts as those of the above description with reference to FIGS. 3A to 3G will be omitted, and only different parts will be described in detail.

FIGS. 4A to 4C are cross-sectional views illustrating a portion of a manufacturing method according to another embodiment of the present invention.

As illustrated in FIGS. 4A and 4B, the protective-film layer 20 is formed over the back surface of the semiconductor substrate 10, and the semiconductor layer 300 including the first semiconductor portion 310, which has a first crystal grain size, is formed over the protective-film layer 20. The description of the process of forming the first semiconductor portion 310 illustrated in FIG. 3B may be directly applied to the process of forming the first semiconductor portion 310. However, the first semiconductor portion 310 has a thickness smaller than the semiconductor layer (see reference numeral 300 in FIG. 3C or reference numeral 30 in FIG. 3E) so as to correspond to the first portion 301 in the process of FIG. 3B, whereas the first semiconductor portion 310 has substantially the same thickness as the semiconductor layer 300 in the process of FIG. 4A. In addition, after the semiconductor layer including the first semiconductor portion 310 is formed, a dopant layer may be formed on the semiconductor layer including the first semiconductor portion 310 prior to forming the second semiconductor portion 320 that will be described below. In the process of forming the second semiconductor portion 320 that will be described below, the dopant layer may be irradiated with a laser so that a dopant included in the dopant layer diffuses to the semiconductor layer including the first semiconductor portion 310.

Subsequently, as illustrated in FIG. 4C, through thermal treatment using a laser 330, the second semiconductor portion 320 is formed in a portion of the first semiconductor portion 310, which is spaced apart from the protective-film layer 20 in the thickness direction. The thermal treatment using the laser 330 enables the growth of crystal grains at a high temperature, whereby the second semiconductor portion 320 may be formed to have a second crystal grain size, which is greater than the first crystal grain size of the first semiconductor portion 310.

By adjusting, for example, the output, energy density, frequency, and pulse of the laser 330 in consideration of, for example, the thickness and properties of the first semiconductor portion 310, the second semiconductor portion 320 may be formed in the state in which a portion of the first semiconductor portion 310 remains close to the protective-film layer 20. The laser 330 may be a short-wave laser. Because the first semiconductor portion 310 easily absorbs a short-wave laser, only a portion of the first semiconductor portion 310 may be easily crystallized. Thus, the second semiconductor portion 320 may be formed so that the first semiconductor portion 310 remains. In one example, the laser 330 may be an ultraviolet (UV) laser or a green laser.

At this time, as illustrated in FIG. 4C, the laser 330 may be emitted in the state in which a separate laser absorption film 320a is formed on the semiconductor layer including the first semiconductor portion 310 before the second semiconductor portion 320 is formed. Thereby, the laser absorption film 320a absorbs some of the laser 330, causing a portion of the semiconductor layer including the first semiconductor portion 310 to be irradiated with the laser 330. Specifically, the crystal grain size of the entire first semiconductor portion 310 is increased in the thickness direction, which may prevent the first semiconductor portion 310 from vanishing. In particular, when the thickness of the laser absorption film 320a is adjusted in consideration of, for example, the thickness and properties of the first semiconductor portion 310, the crystal grain size of only a portion of the first semiconductor portion 310 may be easily increased in the thickness direction. The laser absorption film 320a may be formed of any of various materials so long as the material can absorb the laser 330 and has no negative effect on the first semiconductor portion 310 when it is irradiated with the laser 330. In one example, the laser absorption film 320a may include an insulation layer or an amorphous semiconductor layer (e.g. an amorphous silicon layer). In this instance, the laser absorption layer 320a may be easily formed and may basically include the same material as the first semiconductor portion 310 in order to prevent, for example, contamination and variation in properties due to the use of different materials. The laser absorption film 320a may be formed via various methods after the second semiconductor portion 320 is formed via irradiation of the laser 330.

According to the present embodiment, because some of the laser 330 is absorbed by the laser absorption film 320a, a portion of the first semiconductor portion 310 that is close to the protective-film layer 20 may stably remain so that the first portions 321, 341 and 361 are formed. In addition, the thickness of the first portions 321, 341 and 361 may be easily adjusted via adjustment in the thickness of the laser absorption film 320a.

However, the laser absorption film 320a may be not necessary, and the first semiconductor portion 310 may be directly irradiated with the laser 330 without the laser absorption film 320a. In this instance, the process of forming the laser absorption film 320a may be omitted, resulting in a simplified process.

Subsequently, the solar cell 100 may be manufactured via the implementation of the processes illustrated in FIGS. 3D to 3G.

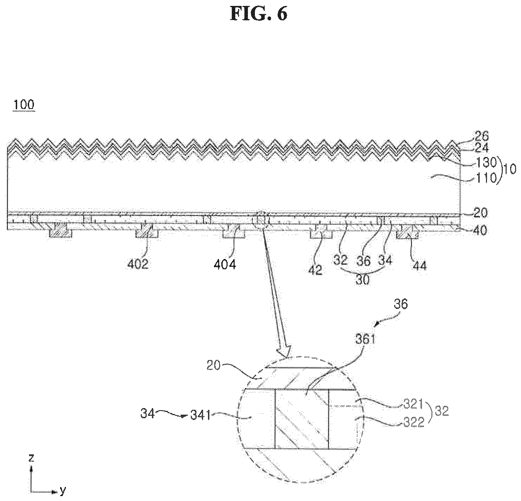

With this manufacturing method, the second semiconductor portion 320 may be simply formed using the laser 330. In particular, because a portion in the plane to be irradiated with the laser 330 may be adjusted, a solar cell having the structure illustrated in FIG. 6 may be formed by irradiating only a portion of the semiconductor layer 300 in the plane with the laser 330. This will be described later in detail with reference to FIG. 6.

Hereinafter, a method of manufacturing a solar cell according to another embodiment of the present invention will be described in detail with reference to FIGS. 5A to 5D. A detailed description of the same or extremely similar parts as those described with reference to FIGS. 3A to 3G and/or those described with reference to FIGS. 4A to 4C will be omitted, and only different parts will be described in detail.

FIGS. 5A to 5D are cross-sectional views illustrating a portion of a manufacturing method according to another embodiment of the present invention.

As illustrated in FIG. 5A, the protective-film layer 20 is formed over the back surface of the semiconductor substrate 10.

Subsequently, as illustrated in FIG. 5B, the semiconductor layer 300 including the first semiconductor portion 310, which has a first crystal grain size, is formed over the protective-film layer 20. The description of the process of forming the first semiconductor portion 310 illustrated in FIG. 3B may be directly applied to the process of forming the first semiconductor portion 310. However, the first semiconductor portion 310 has a thickness smaller than the semiconductor layer (see reference numeral 300 in FIG. 3C or reference numeral 30 in FIG. 3E) so as to correspond to the first portion 301 in the process of FIG. 3B, whereas the first semiconductor portion 310 has substantially the same thickness as the semiconductor layer 300 in the process of FIG. 5B.

Subsequently, as illustrated in FIG. 5C, the first doping layer 324, the mask layer 328, and a second doping layer 329 are formed over the first semiconductor portion 310. At this time, the undoped layer 326 may be located between the first doping layer 324 and the mask layer 328. The description with reference to FIG. 3D may be directly applied to the first doping layer 324, the mask layer 328 and the undoped layer 326, and thus a description thereof will be omitted below.

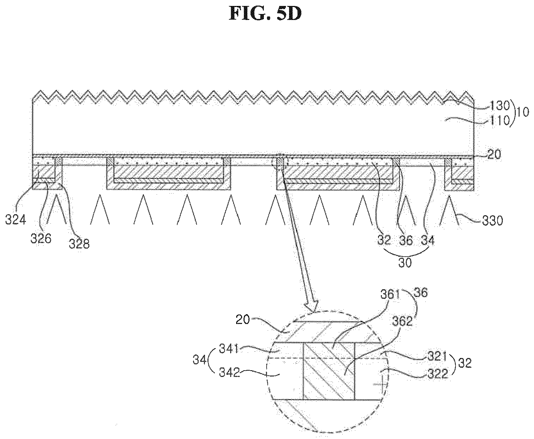

The second doping layer 329 may include a second conductive dopant, and may be formed throughout the semiconductor layer 300, the doping layer 324, the undoped layer 326, and the mask layer 328. The second doping layer 329 including the second conductive dopant serves to supply the second conductive dopant to the semiconductor layer 300 via diffusion in a doping process (i.e. the process illustrated in FIG. 5D).

The second doping layer 329 may be formed of any of various materials including the second conductive dopant. In one example, the second doping layer 329 may include phosphorous silicate glass (PSG). However, the embodiments of the present invention are not limited thereto, and the second doping layer 329 may include any of various other materials. In one example, when the second doping layer 329 is of a p-type, the second doping layer 329 may be formed of boron silicate glass (PSG). The second doping layer 329 may be formed of any of various methods, such as, for example, deposition.

In the above description and the drawings, the first doping layer 324 has a pattern corresponding to the first conductive area 32, the undoped layer 326 and the mask layer 328 are disposed over the first doping layer 324, and the second doping layer 329 is formed throughout the first doping layer 324, the undoped layer 326 and the mask layer 328. However, the embodiments of the present invention are not limited thereto. In one example, the second doping layer 329 may have a pattern corresponding to the second conductive area 34, the undoped layer 326 and the mask layer 328 may be disposed over the second doping layer 329, and the first doping layer 324 may be formed throughout the second doping layer 329, the undoped layer 326 and the mask layer 328. Alternatively, the first doping layer 324 and the second doping layer 329 may respectively have patterns corresponding to the first conductive area 32 and the second conductive area 34.

Subsequently, as illustrated in FIG. 5D, thermal treatment using the laser 330 is performed. Thereby, the first and second conductive areas 32 and 34 are formed via a doping process in which a first conductive dopant in the first doping layer 324 and a second conductive dopant in the second doping layer 329 diffuse to the semiconductor layer 300. The remaining area of the semiconductor layer 300 forms the barrier area 36. In addition, the first portions 321, 341 and 361 are formed because the doping process is performed in the state in which the first semiconductor portion 310 close to the protective-film layer 20 remains, and the second portions 322, 342 and 362 are formed because the doping process is performed on the second semiconductor portion, which is formed when crystal grains are grown by heat of the laser 330 in a portion of the semiconductor layer 300 close to the protective-film layer 20.

According to the present embodiment, because some of the laser 330 is absorbed by, for example, the first or second doping layer 324 or 329, a portion of the first semiconductor portion 310 that is close to the protective-film layer 20 may stably remain to form the first portions 321, 341 and 361. In addition, the thickness of the first portions 321, 341 and 361 may be easily adjusted via adjustment in the thickness of the first or second doping layer 324 or 329. In addition, when the first or second doping layer 324 or 329 required in the doping process is used as a laser absorption layer, additional processes of forming and removing the laser absorption film may be omitted.

FIG. 5D illustrates the instance where the second doping layer 329 is formed and the entire semiconductor layer 300 is irradiated with the laser 330 when viewed in plan. However, the embodiments of the present invention are not limited thereto, and the second doping layer 329 may be omitted, and/or the second conductive area 34 may be formed via a different doping process. In this instance, only a portion of the semiconductor layer 300 in the plane may be irradiated with the laser 330 to form the solar cell having a structure illustrated in FIG. 6. This will be described later in detail with reference to FIG. 6.

In addition, the front surface of the semiconductor substrate 10 may be subjected to texturing to form the front-surface field area 130. This may be understood from the description with reference to FIG. 3E, and thus will not be described below.

Subsequently, the solar cell 100 may be manufactured via the implementation of the processes illustrated in FIGS. 3F and 3G.

In the present embodiment, thermal treatment for doping using the laser 330 and thermal treatment for the formation of the second portions 322, 342 and 362 having a second crystal grain size may be performed at the same time via a single process. Thereby, the doping process and the process of forming the second portions 322 and 342 may be performed in a simplified manner, resulting in a simplified process.

Hereinafter, solar cells according to other embodiments of the present invention will be described in detail with reference to FIGS. 6 to 8. A detailed description of the same or similar parts as those of the above description will be omitted, and only different parts will be described in detail. In addition, the above-described embodiments and alterations thereof and the following embodiments and alterations thereof may be combined with each other within the scope of the present invention.

FIG. 6 is a cross-sectional view illustrating a solar cell according to another embodiment of the present invention.

Referring to FIG. 6, in the present embodiment, the first conductive area 32 includes the first portion 321 having a first crystal grain size and the second portion 322 having a second crystal grain size, which is greater than the first crystal grain size, and the second conductive area 34 includes the first portion 341 having the first crystal grain size. That is, the first portion 341 of the second conductive area 34 may be thicker than the first portion 321 of the first conductive area 32, and the thickness of the first portion 341 may be the same as or similar to (e.g. within a difference of 10% of) the thickness of the first conductive area 32. In addition, the entire second conductive area 34 may have the first crystal grain size and the first crystal grain size of the second conductive area 34 may be substantially the same as or similar to (e.g. with a difference within 10%) the first crystal grain size of the first portion 321 of the first conductive area 32, and may be smaller than the second crystal grain size of the second portion 322 of the first conductive area 32.

In addition, the barrier area 36 may include the first portion 361 having the first crystal grain size. Thus, the first portion 361 of the barrier area 36 may be thicker than the first portion 321 of the first conductive area 32, and the thickness of the first portion 361 may be the same as or similar to (e.g. with a difference within 10%) the thickness of the first conductive area 32. In addition, the entire barrier area 36 may have the first crystal grain size and the first crystal grain size of the barrier area 36 may be substantially the same as or similar to (e.g. with a difference within 10%) the first crystal grain size of the first portion 321 of the first conductive area 32, and may be smaller than the second crystal grain size of the second portion 322 of the first conductive area 32.

The solar cell 100 may be easily manufactured by irradiating only a portion corresponding to the first conductive area 32 with the laser 330 in the process of FIG. 4C or FIG. 5D. However, the embodiments of the present invention are not limited thereto, and the solar cell 100 may be manufactured via various other methods.

At this time, the first conductive area 32 including the first portion 321 and the second portion 322 may be of a p-type. When the first conductive area 32 is of a p-type, a dopant may include, for example, boron (B). This is because boron has a very small element size and thus more easily diffuses to the protective-film layer 20 and the semiconductor substrate 10 than, for example, n-type phosphor (P), thus causing deterioration in properties. In consideration of this, the first conductive area 32 is formed to have the first portion 321 and the second portion 322.

However, the embodiments of the present invention are not limited thereto. The first conductive area 32 may be of an n-type. In addition, in some embodiments, the barrier area 36 may include only the first portion 361, or may include the first portion 361 and the second portion 362.

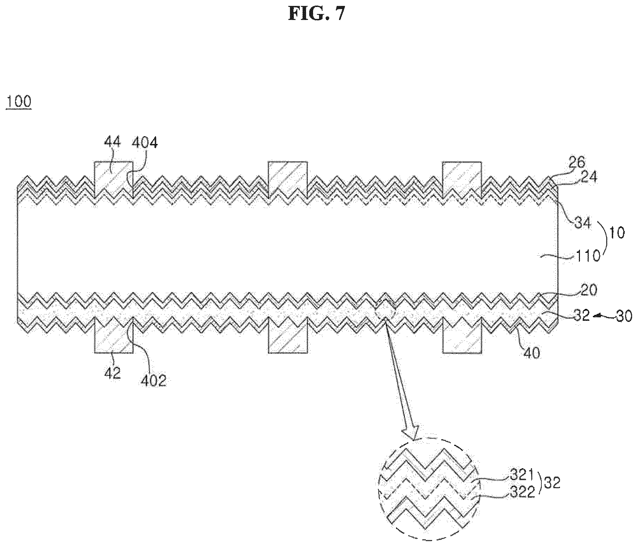

FIG. 7 is a cross-sectional view illustrating a solar cell according to another embodiment of the present invention.

Referring to FIG. 7, in the present embodiment, the protective-film layer 20 and the first conductive area 32 may be formed throughout the back surface of the semiconductor substrate 10, and the second conductive area 34 may be formed throughout the front surface of the semiconductor substrate 10. In addition, the first electrode 42 is electrically connected to the first conductive area 32 at the back surface side of the semiconductor substrate 10, and the second electrode 44 is electrically connected to the second conductive area 34 at the front surface side of the semiconductor substrate 10.

At this time, the first conductive area 32 may be formed as a semiconductor layer, which is separate from the semiconductor substrate 10, and may include the first portion 321 and the second portion 322. The above description related to the first portion 321 and the second portion 322 may be directly applied thereto. In addition, the second conductive area 34 may be formed as a doped area, which constitutes a portion of the semiconductor substrate 10. That is, the second conductive area 34 may be formed by doping a portion of the semiconductor substrate 10 with a dopant. The second conductive area 34 may be of a different conductive type from the base area 110, or may be of the same conductive type as the base area 110, but may have a higher doping concentration than the base area 110.

In one example, in the present embodiment, the second conductive area 34 may be of the same conductive type as the base area 110, but may have a higher doping concentration than the base area 110. Thereby, the first conductive area 34, which is of a different conductive type from the base area 110 and functions as an emitter area, may be formed separately from the semiconductor substrate 10 with the protective-film layer 20 interposed therebetween, which may improve passivation properties. In addition, because the first conductive area 32 configured as a separate semiconductor layer is disposed on the back surface and the second conductive area 34 configured as a doped area is disposed on the front surface, it is possible to prevent, for example, light introduced into the front surface from being absorbed by a separate semiconductor layer. This may minimize shading loss.

As described above, only one of the first and second conductive areas 32 and 34 may include the first portion 321 and the second portion 322. Although FIG. 7 and the detailed description thereof illustrate the instance where the protective-film layer 20 and the first conductive area 32 including the first portion 321 and the second portion 322 are disposed on the back surface of the semiconductor substrate 10 and the second conductive area 34 is disposed on the front surface of the semiconductor substrate 10, the embodiments of the present invention are not limited thereto. For example, the protective-film layer 20 and the first conductive area 32 including the first portion 321 and the second portion 322 may be disposed on the front surface of the semiconductor substrate 10 and the second conductive area 34 may be disposed on the back surface of the semiconductor substrate 10.

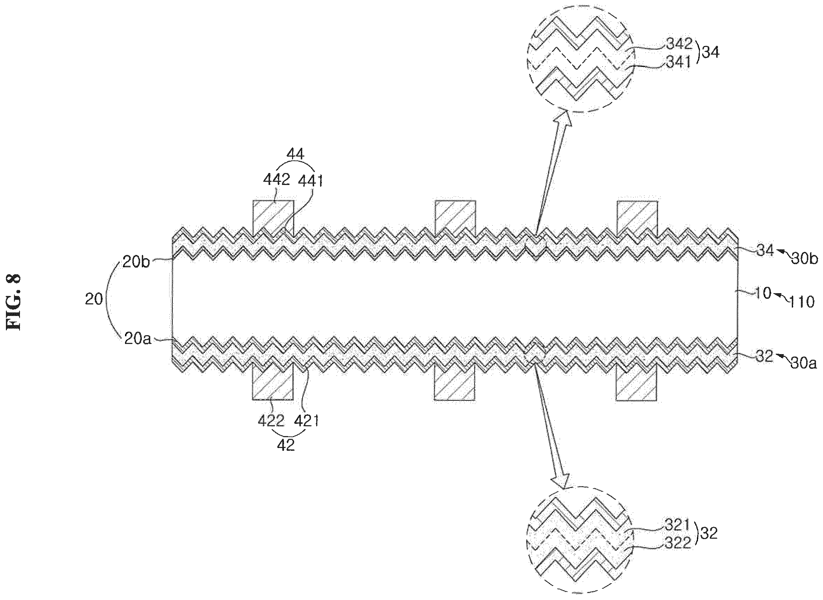

FIG. 8 is a cross-sectional view illustrating a solar cell according to another embodiment of the present invention.

Referring to FIG. 8, in the present embodiment, the protective-film layer 20 may include a first protective-film layer 20a disposed throughout the back surface of the semiconductor substrate 10 and a second protective-film layer 20b disposed throughout the front surface of the semiconductor substrate 10, and the conductive areas 32 and 34 may include the first conductive area 32 disposed throughout the first protective-film layer 20a and the second conductive area 34 disposed throughout the second protective-film layer 20b. In addition, the first electrode 42 is electrically connected to the first conductive area 32 at the back surface side of the semiconductor substrate 10, and the second electrode 44 is electrically connected to the second conductive area 34 at the front surface side of the semiconductor substrate 10.

At this time, the first conductive area 32 and the second conductive area 34 may be formed of semiconductor layers 30a and 30b, which are separated from the semiconductor substrate 10. FIG. 8 illustrates the instance where the first and second conductive area 32 and 34 respectively include the first portions 321 and 341 and the second portions 322 and 342. However, the embodiments of the present invention are not limited thereto, and at least one of the first and second conductive areas 32 and 34 may include the first portion 321 or 341 and the second portion 322 or 342. The description with reference to FIG. 1 may be directly applied to the first portions 321 and 341 and the second portions 322 and 342.

FIG. 8 illustrates one example in which the first electrode 42 includes a first transparent electrode layer 421, which is formed throughout the first conductive area 32, and a first metal electrode layer 422, which has a predetermined pattern above the first transparent electrode layer 421. In addition, in the example of FIG. 8, the second electrode 44 includes a second transparent electrode layer 441, which is formed throughout the second conductive area 34, and a second metal electrode layer 442, which has a predetermined pattern above the second transparent electrode layer 441. When the first and second transparent electrode layers 421 and 441 are provided, resistance in the horizontal direction may be reduced and carrier mobility may be improved. This electrode structure may also be applied to the embodiment illustrated in FIG. 7.

However, the embodiments of the present invention are not limited thereto, and at least one of the first and second electrodes 42 and 44, as illustrated in FIG. 1 or FIG. 7, may be configured as only a metal electrode, which comes into contact with the first and second conductive areas 32 and 34 and has a predetermined pattern.

Hereinafter, the present invention will be described in more detail with reference to manufacturing examples of the present invention. The following manufacturing examples are merely given by way of example, and the embodiments of the present invention are not limited thereto.

### Manufacturing Example 1

A protective-film layer formed of a silicon oxide film was formed on one surface of an n-type monocrystalline semiconductor substrate. A first semiconductor portion, which includes polycrystalline silicon and has a first crystal grain size, was formed over the protective-film layer via low-pressure chemical vapor deposition. A second semiconductor portion was formed by irradiating an intrinsic semiconductor layer with a laser so as to grow crystal grains in a portion of the intrinsic semiconductor layer that is spaced apart from the protective-film layer while remaining the first semiconductor portion in a portion of the semiconductor layer that is close to the protective-film layer. At this time, the first crystal grain size was 50 nm, the second crystal grain size was 250 nm, the difference between the first crystal grain size and the second crystal grain size was 200 nm, and the ratio of the second crystal grain size to the first crystal grain size was 5:1. In addition, an area of the first and second semiconductor portions was doped with a p-type dopant and another area was doped with an n-type dopant so that a semiconductor layer including a first conductive area and a second conductive area each including a first portion and a second portion was formed, whereby a first solar cell was manufactured. The thickness of the second portion relative to the thickness of the entire conductive area was 50%. In addition, second, third and fourth solar cells were manufactured using doping concentrations in the first and second conductive areas that were different from that of the first solar cell of Manufacturing Example 1, but were otherwise manufactured in the same manufacturing method as the first solar cell of Manufacturing Example 1.

### Comparative Example

A first comparative solar cell was manufactured via the same method as the solar cell of Manufacturing Example 1 except that the laser irradiation process of forming the second semiconductor portion was not performed, and thus the semiconductor layer including the first and second conductive areas includes only the first portion, all of which has the first crystal grain size. In addition, second and third comparative solar cells were manufactured using doping concentrations in the first and second conductive areas that were different from that of the first comparative solar cell, but were otherwise manufactured in the same manufacturing method as the first comparative solar cell.

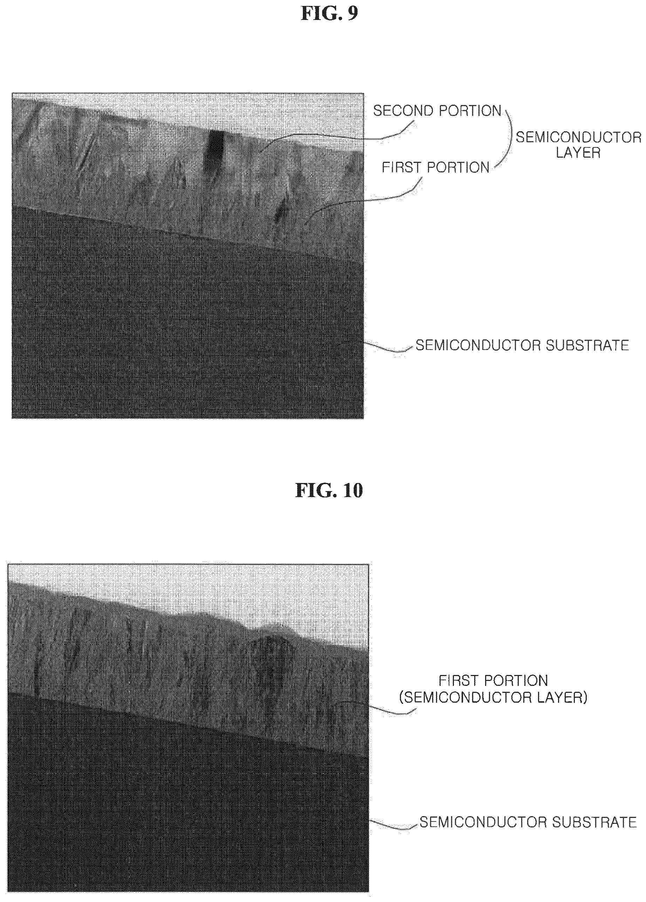

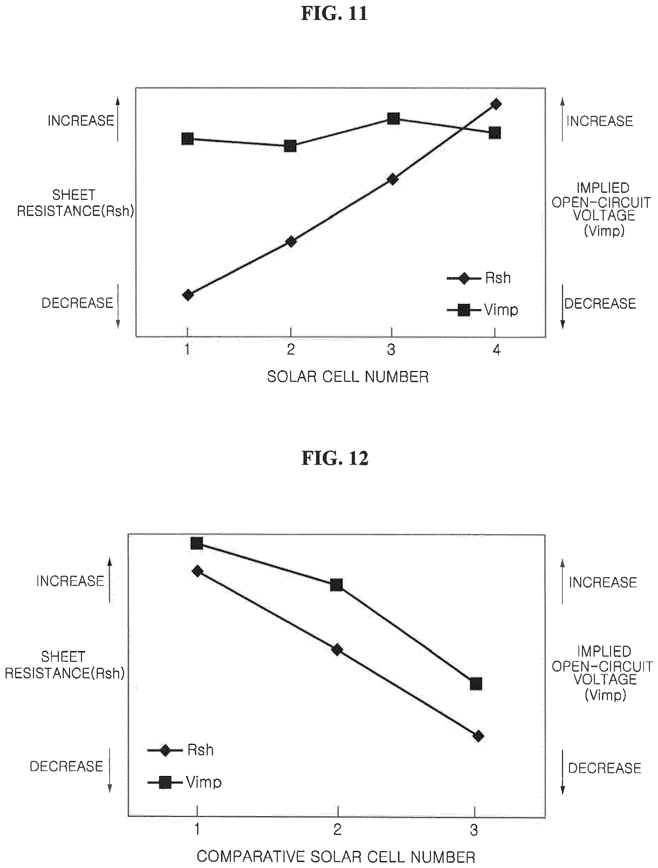

The cross-sectional photograph of the first solar cell of Manufacturing Example 1 is illustrated in FIG. 9, and the cross-sectional of the first comparative solar cell of Comparative Example 1 is illustrated in FIG. 10. In addition, the sheet resistances of the first conductive areas of the first to fourth solar cells according to Manufacturing Example 1 and the implied open-circuit voltage Vimp of the first to fourth solar cells were measured and are illustrated in FIG. 11, and the sheet resistances of the first conductive areas of the first to third comparative solar cells according to Comparative Example 1 and the implied open-circuit voltage Vimp of the first to third solar cells were measured and are illustrated in FIG. 12.

Referring to FIG. 9, it can be seen that, in the solar cells according to Manufacturing Example 1, the semiconductor layer includes the first portion and the second portion having different crystal grain sizes. On the other hand, referring to FIG. 10, it can be seen that, in the solar cells according to Comparative Example 1, the semiconductor layer includes only the first portion having a consistent or nearly consistent crystal grain size.

Referring to FIG. 11, it can be seen that the solar cells according to Manufacturing Example 1 have similar implied open-circuit voltage values even if the sheet resistance values thereof differ from each other. On the other hand, it can be seen that, in the solar cells according to Comparative Example 1, the implied open-circuit voltage is reduced in proportion to the reduction in sheet resistance. In Comparative Example 1, it is expected that, when the sheet resistance is reduced by increasing the doping concentration, a dopant may move to the protective-film layer, causing deterioration in passivation at the interface of the protective-film layer. On the other hand, in Manufacturing Example 1, it is expected that, when the second portion having a relatively large second crystal grain size is located over the first portion so as to reduce the diffusion rate of a dopant, the surface concentration may be reduced and the doping concentration of the first portion, which is located close to the protective-film layer, may be reduced. With Manufacturing Example 1 described above, the second portion may prevent deterioration in passivation that is caused when a dopant moves to the interface of the protective-film layer, and resistance between the second portion having a high doping concentration and the second electrode may be reduced. Thereby, a high open-circuit voltage may be acquired even at a low sheet resistance, which may effectively improve the efficiency of the solar cell.

### Comparative Example 2

A solar cell was manufactured via the same method as the first solar cell of Manufacturing Example 1 except that the first crystal grain size was 50 nm, the second crystal grain size was 58 nm, the difference between the first crystal grain size and the second crystal grain size was 8 nm, and the ratio of the second crystal grain size to the first crystal grain size was 1.16:1.

### Manufacturing Example 2

A solar cell was manufactured via the same method as the first solar cell of Manufacturing Example 1 except that the thickness of the second portion relative to the thickness of the entire conductive area was 10%.

### Manufacturing Example 3

A solar cell was manufactured via the same method as the first solar cell of Manufacturing Example 1 except that the thickness of the second portion relative to the thickness of the entire conductive area was 83%.

### Manufacturing Example 4

A solar cell was manufactured via the same method as the first solar cell of Manufacturing Example 1 except that the thickness of the second portion relative to the thickness of the entire conductive area was 88%.

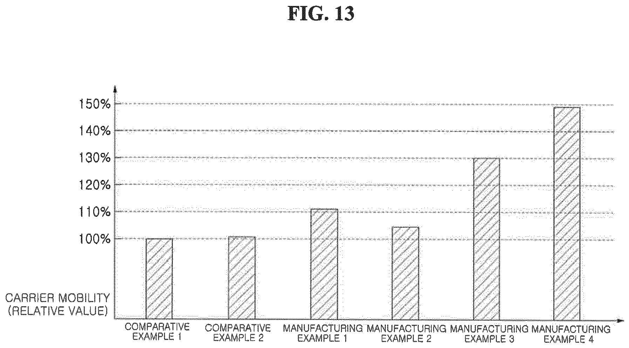

The relative values of the carrier mobility in the first conductive areas of the first solar cell according to Manufacturing Example 1, the first comparative solar cell according to Comparative Example 1, and the solar cells according to Comparative Example 2 and Manufacturing Examples 2 to 4 are illustrated in FIG. 13.

Referring to FIG. 13, it can be seen that the carrier mobility in the first solar cell according to Manufacturing Example 1 is higher than the carrier mobility in the first comparative solar cell according to Comparative Example 1. On the other hand, it can be seen that, when the solar cell according to Comparative Example 2 has carrier mobility similar to the solar cell according to Comparative Example 1, and thus has a crystal grain size below a predetermined level (e.g. 10 nm) or the ratio of the crystal grain size of the second portion to the first portion below a predetermined level (e.g. 1.5:1), even if the first and second portion are provided, almost none of the effects thereof are apparent. In addition, it can be seen that the solar cell according to Manufacturing Example 2 has carrier mobility higher than the first comparative solar cell according to Comparative Example 1, but the difference therebetween is not large. In addition, it can be seen that the solar cells according to Manufacturing Examples 3 and 4 have carrier mobility greatly superior to the first comparative solar cell according to Comparative Example 1 and the solar cell according to Manufacturing Example 1. Accordingly, it can be seen that, when the difference between the first crystal grain size and the second crystal grain size is a predetermined level or more (e.g. 10 nm or more) or when the ratio of the second crystal grain size to the first crystal grain size is a predetermined level (e.g. 1.5:1 or more), the effects thereof may clearly appear and the carrier mobility may be considerably increased as the second portion becomes thicker than the first portion. However, when the thickness of the second portion is excessively increased (e.g. the thickness of the second portion exceeds 90% of the thickness of the entire conductive area), it may be difficult to sufficiently dope the entire conductive area, and the properties of the conductive area may be deteriorated.

## Claims

1. A solar cell comprising:
a semiconductor substrate (10);
a protective-film layer (20) formed over one surface of the semiconductor substrate;
a first conductive area (32) disposed over the protective-film layer, the first conductive area being of a first conductive type and including a crystalline semiconductor; and
a first electrode (42) electrically connected to the first conductive area,
wherein the first conductive area includes a first portion (321) disposed over the protective-film layer and having a first crystal grain size, and a second portion (322) disposed over the first portion and having a second crystal grain size, which is greater than the first crystal grain size,
**characterized in that** a doping concentration of the first portion (321) is lower than that of the second portion (322).

2. The solar cell according to claim 1, wherein: the first crystal grain size ranges from 10 nm to 1 µm, and the second crystal grain size ranges from 20 nm to 600 µm; or
a difference between the first crystal grain size and the second crystal grain size ranges from 10 nm to 600 µm; or
a ratio of the first crystal grain size to the second crystal grain size ranges from 1:1.5 to 1:100.

3. The solar cell according to any one preceding claim, wherein a thickness of the second portion (322) relative to a thickness of the entire first conductive area (32) ranges from 20% to 90%.

4. The solar cell according to any one preceding claim, wherein the second portion (322) has a thickness that is equal to or greater than that of the first portion (321).

5. The solar cell according to any one preceding claim, further comprising:
a second conductive area (34) disposed over the protective-film layer (20), the second conductive area being of a second conductive type, which is different from the first conductive type; and
a second electrode (44) electrically connected to the second conductive area.

6. The solar cell according to claim 5, wherein only the first conductive area (32) includes the first portion (321) and the second portion (322), and the second conductive area (34) includes only the first portion (341) without including the second portion.

7. The solar cell according to claim 5, wherein the second conductive area (34) includes a crystalline semiconductor of the second conductive type, and includes a first portion (341) and a second portion (342) disposed over the first portion so as to be close to the second electrode, and
wherein the second portion has a crystal grain size greater than that of the first portion.

8. The solar cell according to claim 5, wherein the second conductive area (34) is disposed over the protective-film layer (20) in the same plane as the first conductive area (32) and includes a crystalline semiconductor.

9. The solar cell according to claim 5, wherein the second conductive area (34) is configured as a doped area formed on a remaining surface of the semiconductor substrate (10) by doping a portion of the semiconductor substrate.

10. A method of manufacturing a solar cell, the method comprising:
forming a protective-film layer over a semiconductor substrate;
forming a conductive area having crystallinity over the protective-film layer; and
forming an electrode electrically connected to the conductive area,
wherein, in the forming the conductive area, the conductive area is formed to include a first portion, which is disposed over the protective-film layer and has a first crystal grain size, and a second portion, which is disposed over the first portion and has a second crystal grain size, which is greater than the first crystal grain size, and
doping the conductive area,
**characterized in that** a doping concentration of the first portion is lower than that of the second portion.

11. The method according to claim 10, wherein the forming the conductive area includes:
forming a first semiconductor portion, having the first crystal grain size, over the protective-film layer using a first process condition; and
forming a second semiconductor portion, having the second crystal grain size, over the first semiconductor portion using a second process condition, which is different from the first process condition.

12. The method according to claim 11, wherein the forming the first semiconductor portion and the forming the second semiconductor portion are performed via successive in-situ processes having different process conditions.

13. The method according to any one of claims 11 to 12, wherein, in the forming the conductive area, the first and second semiconductor portions are formed via low-pressure chemical vapor deposition, and
wherein a temperature in the forming the second semiconductor portion is higher than a temperature in the forming the first semiconductor portion, or an amount of gas including a semiconductor material in the forming the second semiconductor portion is greater than an amount of gas including a semiconductor material in the forming the first semiconductor portion.

14. The method according to any one of claims 10 to 13, wherein the forming the conductive area includes:
forming a semiconductor layer over the protective-film layer, the semiconductor layer including a first semiconductor portion, which has the first crystal grain size; and
forming a second semiconductor portion located over the first semiconductor portion and spaced apart from the protective-film layer by irradiating a portion of the semiconductor layer with a laser, the second semiconductor portion having the second crystal grain size, which is greater than the first crystal grain size,.

15. The method according to claim 14, wherein the forming the conductive area further includes forming a laser absorption film over the semiconductor layer, prior to forming the second semiconductor portion, and
wherein, in the forming the second semiconductor portion, the portion of the semiconductor layer is irradiated with the laser through the laser absorption film.

## Patentansprüche

1. Solarzelle, umfassend:
ein Halbleitersubstrat (10);
eine Schutzfilmschicht (20), die über einer Oberfläche des Halbleitersubstrats gebildet ist;
ein erster leitfähiger Bereich (32), der über der Schutzfilmschicht angeordnet ist, wobei der erste leitfähige Bereich von einem ersten Leitfähigkeitstyp ist und einen kristallinen Halbleiter enthält; und
eine erste Elektrode (42), die elektrisch mit dem ersten leitfähigen Bereich verbunden ist, wobei der erste leitfähige Bereich einen ersten Abschnitt (321), der über der Schutzfilmschicht angeordnet ist und eine erste Kristallkorngröße aufweist, und einen zweiten Abschnitt (322), der über dem ersten Abschnitt angeordnet ist und eine zweite Kristallkorngröße aufweist, die größer ist als die erste Kristallkorngröße, enthält,
**dadurch gekennzeichnet, dass** eine Dotierkonzentration des ersten Abschnitts (321) niedriger ist als die des zweiten Abschnitts (322).

2. Solarzelle nach Anspruch 1, wobei: die erste Kristallkorngröße im Bereich von 10 nm bis 1 µm liegt und die zweite Kristallkorngröße im Bereich von 20 nm bis 600 µm liegt; oder
wobei eine Differenz zwischen der ersten Kristallkorngröße und der zweiten Kristallkorngröße im Bereich von 10 nm bis 600 µm liegt; oder
wobei ein Verhältnis der ersten Kristallkorngröße zu der zweiten Kristallkorngröße im Bereich von 1:1,5 bis 1:100 liegt.

3. Solarzelle nach einem beliebigen der vorhergehenden Ansprüche, wobei eine Dicke des zweiten Abschnitts (322) bezogen auf eine Dicke des gesamten ersten leitfähigen Bereichs (32) im Bereich von 20% bis 90% liegt.

4. Solarzelle nach einem beliebigen der vorhergehenden Ansprüche, wobei der zweite Abschnitt (322) eine Dicke aufweist, die gleich oder größer ist als die des ersten Abschnitts (321).

5. Solarzelle nach einem beliebigen der vorhergehenden Ansprüche, des Weiteren umfassend:
einen zweiten leitfähigen Bereich (34), der über der Schutzfilmschicht (20) angeordnet ist, wobei der zweite leitfähige Bereich von einem zweiten Leitfähigkeitstyp ist, welcher sich von dem ersten Leitfähigkeitstyp unterscheidet; und
eine zweite Elektrode (44), die elektrisch mit dem zweiten leitfähigen Bereich verbunden ist.

6. Solarzelle nach Anspruch 5, wobei nur der erste leitfähige Bereich (32) den ersten Abschnitt (321) und den zweiten Abschnitt (322) enthält, und wobei der zweite leitfähige Bereich (34) nur den ersten Abschnitt (341) ohne den zweiten Abschnitt enthält.

7. Solarzelle nach Anspruch 5, wobei der zweite leitfähige Bereich (34) einen kristallinen Halbleiter vom zweiten Leitfähigkeitstyp enthält und einen ersten Abschnitt (341) und einen zweiten Abschnitt (342) enthält, der so über dem ersten Abschnitt angeordnet ist, dass er sich in der Nähe der zweiten Elektrode befindet, und
wobei der zweite Abschnitt eine Kristallkorngröße aufweist, welche größer ist als die des ersten Abschnitts.

8. Solarzelle nach Anspruch 5, wobei der zweite leitfähige Bereich (34) über der Schutzfilmschicht (20) in der gleichen Ebene wie der erste leitfähige Bereich (32) angeordnet ist und einen kristallinen Halbleiter enthält.

9. Solarzelle nach Anspruch 5, wobei der zweite leitfähige Bereich (34) als ein dotierter Bereich eingerichtet ist, der auf einer verbleibenden Oberfläche des Halbleitersubstrats (10) durch Dotieren eines Abschnitts des Halbleitersubstrats gebildet ist.

10. Verfahren zum Herstellen einer Solarzelle, wobei das Verfahren umfasst:
Bilden einer Schutzfilmschicht über einem Halbleitersubstrat;
Bilden eines leitfähigen Bereichs mit einer Kristallinität über der Schutzfilmschicht; und
Bilden einer Elektrode, die elektrisch mit dem leitfähigen Bereich verbunden ist, wobei bei der der Bildung des leitfähigen Bereichs der leitfähige Bereich so gebildet wird, dass er einen ersten Abschnitt enthält, welcher über der Schutzfilmschicht angeordnet ist und eine erste Kristallkorngröße aufweist, und einen zweiten Abschnitt enthält, welcher über dem ersten Abschnitt liegt und eine zweite Kristallkorngröße aufweist, die größer ist als die erste Kristallkorngröße, und
Dotieren des leitfähigen Bereichs,
**dadurch gekennzeichnet, dass** eine Dotierkonzentration des ersten Abschnitts niedriger ist als die des zweiten Abschnitts.

11. Verfahren nach Anspruch 10, wobei die Bildung des leitfähigen Bereichs umfasst:
Bilden eines ersten leitfähigen Abschnitts mit der ersten Kristallkorngröße über der Schutzfilmschicht unter Verwendung einer ersten Verfahrensbedingung; und
Bilden eines zweiten leitfähigen Abschnitts mit der zweiten Kristallkorngröße über dem ersten Halbleiterabschnitt unter Verwendung einer zweiten Verfahrensbedingung, welche sich von der ersten Verfahrensbedingung unterscheidet.

12. Verfahren nach Anspruch 11, wobei die Bildung des ersten Halbleiterabschnitts und die Bildung des zweiten Halbleiterabschnitts durch aufeinanderfolgende in-situ-Verfahren mit unterschiedlichen Verfahrensbedingungen durchgeführt werden.

13. Verfahren nach einem der Ansprüche 11 bis 12, wobei bei der Bildung des leitfähigen Bereichs die ersten und zweiten Halbleiterabschnitte durch chemische Gasphasenabscheidung bei niedrigem Druck gebildet werden, und
wobei eine Temperatur bei der Bildung des zweiten Halbleiterabschnitts höher ist als eine Temperatur bei der Bildung des ersten Halbleiterabschnitts, oder wobei eine Menge an Gas mit einem Halbleitermaterial bei der Bildung des zweiten Halbleiterabschnitts größer ist als eine Menge an Gas mit einem Halbleitermaterial bei der Bildung des ersten Halbleiterabschnitts.

14. Verfahren nach einem der Ansprüche 10 bis 13, wobei die Bildung des leitfähigen Bereichs umfasst;
Bilden einer Halbleiterschicht über der Schutzfilmschicht, wobei die Halbleiterschicht einen ersten Halbleiterabschnitt enthält, welcher die erste Kristallkorngröße aufweist; und
Bilden eines zweiten Halbleiterabschnitts über dem ersten Halbleiterabschnitt und im Abstand von der Schutzfilmschicht durch Bestrahlen eines Abschnitts der Halbleiterschicht mit einem Laser, wobei der zweite Halbleiterabschnitt die zweite Kristallkorngröße aufweist, welche größer ist als die erste Kristallkorngröße.

15. Verfahren nach Anspruch 14, wobei die Bildung des leitfähigen Bereichs des Weiteren die Bildung eines Laserabsorptionsfilms über der Halbleiterschicht vor der Bildung des zweiten Halbleiterschnitts umfasst, und
wobei während der Bildung des zweiten Halbleiterabschnitts der Abschnitt der Halbleiterschicht mit dem Laser durch den Laserabsorptionsfilm bestrahlt wird.

## Revendications

1. Cellule solaire comprenant :
un substrat semi-conducteur (10) ;
une couche de film protecteur (20) formée sur une surface du substrat semi-conducteur ;
une première zone conductrice (32) disposée sur la couche de film protecteur, la première zone conductrice étant d'un premier type conducteur et comprenant un semi-conducteur cristallin ; et
une première électrode (42) connectée électriquement à la première zone conductrice,
dans laquelle la première zone conductrice comprend une première partie (321) disposée sur la couche de film protecteur et ayant une première taille de grain cristallin, et une seconde partie (322) disposée sur la première partie et ayant une seconde taille de grain cristallin, qui est supérieure à la première taille de grain cristallin,
**caractérisée en ce que** la concentration de dopage de la première partie (321) est inférieure à celle de la seconde partie (322).

2. Cellule solaire selon la revendication 1, dans laquelle : la première taille de grain cristallin est comprise entre 10 nm et 1 µm, et la seconde taille de grain cristallin est comprise entre 20 nm et 600 µm ; ou
une différence entre la première taille de grain cristallin et la seconde taille de grain cristallin est comprise entre 10 nm et 600 µm ; ou
un rapport de la première taille de grain cristallin à la seconde taille de grain cristallin est compris entre 1:1,5 et 1:100.

3. Cellule solaire selon l'une quelconque des revendications précédentes, dans laquelle l'épaisseur de la seconde partie (322) par rapport à l'épaisseur de la totalité de la première zone conductrice (32) est comprise entre 20 % et 90 %.

4. Cellule solaire selon l'une quelconque des revendications précédentes, dans laquelle la seconde partie (322) a une épaisseur qui est supérieure ou égale à celle de la première partie (321).

5. Cellule solaire selon l'une quelconque des revendications précédentes, comprenant en outre :
une seconde zone conductrice (34) disposée sur la couche de film protecteur (20), la seconde zone conductrice étant d'un second type conducteur, qui est différent du premier type conducteur ; et
une seconde électrode (44) connectée électriquement à la seconde zone conductrice.

6. Cellule solaire selon la revendication 5, dans laquelle seule la première zone conductrice (32) comprend la première partie (321) et la seconde partie (322), et la seconde zone conductrice (34) ne comprend que la première partie (341) sans inclure la seconde partie.

7. Cellule solaire selon la revendication 5, dans laquelle la seconde zone conductrice (34) comprend un semi-conducteur cristallin du second type conducteur, et comprend une première partie (341) et une seconde partie (342) disposée sur la première partie de manière à être proche de la seconde électrode, et
dans laquelle la seconde partie a une taille de grain cristallin supérieure à celle de la première partie.

8. Cellule solaire selon la revendication 5, dans laquelle la seconde zone conductrice (34) est disposée sur la couche de film protecteur (20) dans le même plan que la première zone conductrice (32) et comprend un semi-conducteur cristallin.

9. Cellule solaire selon la revendication 5, dans laquelle la seconde zone conductrice (34) est conçue en tant que zone dopée formée sur une surface restante du substrat semi-conducteur (10) par dopage d'une partie du substrat semi-conducteur.

10. Procédé de fabrication d'une cellule solaire, le procédé comprenant :
la formation d'une couche de film protecteur sur un substrat semi-conducteur ;
la formation d'une zone conductrice ayant une certaine cristallinité sur la couche de film protecteur ; et
la formation d'une électrode connectée électriquement à la zone conductrice,
dans lequel, lors de la formation de la zone conductrice, la zone conductrice est formée pour inclure une première partie, qui est disposée sur la couche de film protecteur et qui a une première taille de grain cristallin et une seconde partie, qui est disposée sur la première partie et qui a une seconde taille de grain cristallin, qui est supérieure à la première taille de grain cristallin, et
le dopage de la zone conductrice,
**caractérisé en ce que** la concentration de dopage de la première partie est inférieure à celle de la seconde partie.

11. Procédé selon la revendication 10, dans lequel la formation de la zone conductrice comprend :
la formation d'une première partie semi-conductrice, ayant la première taille de grain cristallin, sur la couche de film protecteur à l'aide d'une première condition de traitement ; et
la formation d'une seconde partie semi-conductrice, ayant la seconde taille de grain cristallin, sur la première partie semi-conductrice à l'aide d'une seconde condition de traitement, qui est différente de la première condition de traitement.

12. Procédé selon la revendication 11, dans lequel la formation de la première partie semi-conductrice et la formation de la seconde partie semi-conductrice sont effectuées via des processus in-situ successifs présentant des conditions de traitement différentes.

13. Procédé selon l'une quelconque des revendications 11 à 12, dans lequel, lors de la formation de la zone conductrice, les première et seconde parties semiconductrices sont formées via un dépôt chimique en phase vapeur à basse pression, et
dans lequel une température lors de la formation de la seconde partie semi-conductrice est supérieure à une température lors de la formation de la première partie semi-conductrice, ou une quantité de gaz comprenant un matériau semi-conducteur lors de la formation de la seconde partie semi-conductrice est supérieure à une quantité de gaz comprenant un matériau semi-conducteur lors de la formation de la première partie semi-conductrice.

14. Procédé selon l'une quelconque des revendications 10 à 13, dans lequel la formation de la zone conductrice comprend :
la formation d'une couche semi-conductrice sur la couche de film protecteur, la couche semi-conductrice comprenant une première partie semi-conductrice, qui a la première taille de grain cristallin ; et
la formation d'une seconde partie semi-conductrice située sur la première partie semi-conductrice et espacée de la couche de film protecteur par exposition d'une partie de la couche semi-conductrice à un laser, la seconde partie semi-conductrice ayant la seconde taille de grain cristallin supérieure à celle de la première taille de grain cristallin.

15. Procédé selon la revendication 14, dans lequel la formation de la zone conductrice comprend en outre la formation d'un film d'absorption laser sur la couche semi-conductrice, avant la formation de la seconde partie semi-conductrice, et
dans lequel, lors de la formation de la seconde partie semi-conductrice, la partie de la couche semi-conductrice est exposée au laser à travers le film d'absorption laser.
